# EUROPÄISCHE PATENTSCHRIFT

(11) **EP 1 102 414 B1**
(45) Veröffentlichungstag und Bekanntmachung des Hinweises auf die Patenterteilung: **17.12.2003**
(21) Anmeldenummer: 01104837.8
(22) Anmeldetag: 03.11.1997
(51) Int. Cl.: H04B 1/69

(54) **Verfahren zur drahtlosen Übertragung einer Nachricht**
Method for wireless information transfer
Procédé de transmission sans fil d'une information

(30) Priorität: 01.11.1996 DE 19646747
(43) Veröffentlichungstag der Anmeldung: 23.05.2001
(62) Teilanmeldung aus: 97949886.2
(73) Patentinhaber: Nanotron Technologies GmbH, 10555 Berlin (DE)
(72) Erfinder: Koslar, Manfred, 10629 Berlin (DE); Ianelli, Zbigniew, 13355 Berlin (DE)
(74) Vertreter: Eisenführ, Speiser & Partner

(56) Entgegenhaltungen:
- WO-A-95/20277
- US-A- 4 255 791
- US-A- 5 070 500
- US-A- 5 105 294
- US-A- 5 113 278
- US-A- 5 325 394
- KOWATSCH ET AL.: "Spread-Spectrum-übertragung analoger Signale mit Chirp-Modulation" ARCHIV FÜR ELEKTRONIK UND ÜBERTRAGUNGSTECHNIK, Bd. 36, Juli 1982 (1982-07), Seiten 299-304, XP002061685

## Beschreibung

Die Erfindung betrifft ein Verfahren gemäß dem Oberbegriff des Anspruchs 1 sowie eine Sender- und Empfänger-Anordnung gemäß dem Oberbegriff des Anspruches 11. Ein solches Verfahren und eine solche Sender- und Empfängeranordnung ist bekannt aus US 5,105,294 bzw. 5,113,278.

Bei bekannten, jedem Fachmann aus Standardwerken geläufigen drahtlosen Nachrichtenübertragungsverfahren 'wird das zu übertragende Nachrichtensignal im Sender durch einen Modulator einem hochfrequenten Trägersignal aufmoduliert und über eine Übertragungsstrecke dem Empfänger übermittelt, der zur Rückgewinnung des Nachrichtensignals einen entsprechenden Demodulator aufweist. Ein bekanntes Modulationsverfahren der Nachrichtentechnik ist die Winkelmodulation (als Oberbegriff für Frequenz- und Phasenmodulation).

Liegt das zu übertragende Nachrichtensignal in digitalisierter Form als Bitfolge vor, wie es vorzugsweise in modernen Mobilfunknetzen der Fall ist, so erfolgt die Modulation durch Änderung der Frequenz bzw. Phase oder der Amplitude des Trägersignals in Abhängigkeit von der zu übertragenden Bitfolge. Beispielsweise aus COUCH, L.W.: Digital and Analog Communication Systems, 4^{th} Edition, Macmillan Publishing Company (1993), sind verschiedenee digitale Modulationsverfahren bekannt, darunter die Amplitudentastung (ASK : Amplitude Shift Keying), die Zweiphasenumtastung (2-PSK : Phase Shift Keying) oder die Zweifrequenzumtastung (2-FSK : Frequency Shift Keying). Auch hier erfolgt im Empfänger jeweils die Demodulation entsprechend dem senderseitig angewandten Modulationsverfahren und damit die Rückgewinnung des digitalen Nachrichtensignals als Bitfolge in Form von aufeinanderfolgenden Impulsen.

Dem Fachmann ist - etwa aus der analogen Fernsehtechnik, wo die Restseitenbandamplitudenmodulation für das Luminanzsignal, die Frequenzmodulation für das Audiosignal und die IQ-Modulation für das Chrominanzsignal genutzt werden - auch die Anwendung mehrerer verschiedener Modulationsverfahren für verschiedene Nachrichten bzw. Nachrichtenkomponenten im Rahmen eines zusammenhängenden Übertragungsvorganges geläufig. Auch hier dient die Variation der Trägerparameter einzig dem Aufprägen der Nachricht und hat keinen Einfluß auf Störungen der Übertragungsstrecke.

Aus der Radartechnik ist ein Verfahren zur senderseitigen Dehnung und empfängerseitigen Kompression der ausgesandten Ortungsimpulse ("Chirp"-Verfahren) bekannt; vgl. etwa E. Philippow (Hrsg.): Taschenbuch der Elektrotechnik, Band 4: Systeme der Informationstechnik, Berlin 1985, S. 340/341. Hierbei werden zur Kompression eine analoge Frequenzmodulation oder eine digitale Phasenmodulation angewandt, es erfolgt jedoch keine Aufprägung einer Nachricht. Dieses Verfahren dient der Herabsetzung der aufgewandten Sendeleitung und damit der Detektierbarkeit der Signale durch einen eventuellen Gegner bei gleichzeitiger Erhaltung der Erfassungsreichweite und -genauigkeit.

Bei allen Nachrichtenübertragungsverfahren besteht das grundsätzliche physikalische Problem, daß die Qualität des empfängerseitig zurückgewonnenen Nachrichtensignals und mit (in der Praxis stets vorhandenen) Störungen auf der Übertragungsstrecke und infolgedessen mit der Entfernung zwischen Sender und Empfänger abnimmt. Um bei einer Nachrichtenübertragung auf einer störungsbehafteten Übertragungsstrecke eine gewünschte Reichweite mit einer vorgegebenen Störsicherheit zu erreichen, ist daher eine bestimmte Sendeleistung nötig, die beispielsweise bei der mobilen Kommunikation im Watt-Bereich liegt.

Zum einen hat die erforderliche Sendeleistung den Nachteil, daß der Energieverbrauch während des Sendebetriebs entsprechend hoch ist, was insbesondere bei batterie- oder akkubetriebenen Geräten wie Mobiltelefonen wegen der raschen Erschöpfung des Energiespeichers störend ist. Zum anderen erhöht sich mit der durch die explosionsartige Verbreitung von Mobiltelefonen, die zunehmende Anzahl von Rundfunk- und Fernsehprogrammanbietern etc. ansteigenden Anzahl von Nachrichtensendern die Gesamtbelastung an elektromagnetischer Strahlung für den Menschen (sog. "human exposure"). Schädigungen des menschlichen Körpers sind insbesondere bei Mobiltelefonen mit der derzeit üblichen Sendeleistung wegen des sehr geringen Abstands des Senders zum Kopf des Benutzers nicht auszuschließen.

Der Erfindung liegt daher die Aufgabe zugrunde, ein Verfahren der eingangs genannten Art bzw. eine Anordnung zu dessen Durchführung zu schaffen, die bei mindestens gleichbleibender Übertragungsqualität eine Verringerung der Sendeleistung und/oder Erhöhung der Reichweite ermöglichen.

Diese Aufgabe wird durch ein Verfahren mit den Merkmalen nach Anspruch 1 sowie durch eine Sender- und Empfänger-Anordnung mit den Merkmalen nach Anspruch 11 gelöst.

Die Erfindung schließt den grundsätzlichen Gedanken ein, zwei voneinander unabhängige Modulationsverfahren dazu einzusetzen, zum einen die Nachricht einem Träger aufzuprägen (Informationssignalmodulation) und zum anderen eine weitgehende Unterdrückung von Störungen auf der Übertragungsstrecke, insbesondere des thermischen oder "weißen" Rauschens, zu erreichen (Trägersignalmodulation).

Die mittels eines an sich bekannten Verfahrens der Nachrichtentechnik mit der Nachricht modulierten bzw. zu modulierenden Impulse werden im Sender einer Winkelmodulation (was hier als Oberbegriff für Phasen- und Frequenzmodulation zu verstehen ist) mit einer speziellen Kennlinie unterzogen. Die winkelmodulierten, ein vorbestimmtes Frequenzspektrum aufweisenden Impulse werden im Empfänger durch Aufprägung einer frequenzabhängige Verzögerung zeitlich komprimiert. Damit ergibt sich am Empfängerausgang - bezogen auf die Amplitude des Sendesignals und somit auch gegenüber dem Störpegel - eine Amplitudenüberhöhung. Diese Impulskompression/Amplitudenüberhöhung läßt sich insbesondere mittels eines dispersiven Filters durchführen. Aus dem so bearbeiteten Träger wird durch Demodulation das Informationssignal zurückgewonnen, wobei die Informationssignal-Demodulation mit einem durch die Amplitudenüberhöhung verbesserten Signal-/Rauschverhältnis erfolgen kann.

Dessen Verbesserung ist abhängig vom Bandbreite-Zeit-Produkt aus der bei der Winkelmodulation eingesetzten Bandbreite und der Impulsdauer und bei schlechten Übertragungsbedingungen besonders markant.

Die eigentliche Nachricht kann dem Träger durch Impulsmodulationsverfahren aufgeprägt werden oder dadurch, daß die Trägerkompression für verschiedene Zustände des Nachrichtensignals in auswertbar unterschiedlicher Weise vorgenommen wird, so daß diese Variation der Winkelmodulation die Nachricht enthält. Wichtig ist hierbei, daß die Nachrichten-Modulation auf die Signallaufzeit ohne oder nur von untergeordnetem Einfluß ist.

Nach der Demodulation steht ein Signal in einer Qualität zur Verfügung, die nach dem Stand der Technik nur mit einer erhöhten Sendeleistung oder aufwendigen Verfahren zur Empfangsverbesserung (wie Diversity-Empfang oder redundante Übertragung) erzielt werden könnte. Ein weiterer Vorteil des erfindungsgemäßen Verfahrens ist in dem wesentlich geringeren Störpotential gegenüber anderen Übertrgaungsstrekken zu sehen, da mit einer geringeren Sendeleistung ein vorgegebenes Signal/Rausch-Verhältnis nach der Impulskompression im Empfänger erreichbar ist. Darüber hinaus führen die geringeren Anforderungen an die Sendeleistung zu einer verringerten Human exposure. Der mit dem Verfahren verbundene Nachteil einer größeren benötigten Bandbreite und damit verringerten Kanalkapazität bzw. Übertragungsrate (Bitrate) kann für viele Anwendungsfälle in Kauf genommen werden und läßt sich durch Wahl eines angepaßten Pulsmodulationsverfahrens für die Nachrichten-Modulation teilweise eliminieren (siehe weiter unten).

Für die variable Winkelmodulation wird eine besondere Winkelmodulations-Zeitcharakteristik verwendet, welche sozusagen einer "Modulationskennlinie" entspricht. Die Modulationskennlinie - hier allgemein Modulationscharakteristik genannt - bestimmt hierbei den zeitlichen Verlauf der Frequenz jeweils während der Dauer eines Impulses. Bei Anwendung einer linear fallenden Modulationscharakteristik nimmt die Frequenz des übertragenen Signals jeweils während der Dauer eines Impulses von einem oberhalb der Trägerfrequenz liegenden Wert linear auf einen unterhalb der Trägerfrequenz liegenden Wert ab. Analog ist ein linear steigende Kennlinie einsetzbar. Das empfängerseitige Filter ist der verwendeten Modulationscharakteristik durch ein entsprechendes differentielles frequenzabhängiges Laufzeitverhalten (Gruppenlaufzeitverhalten) in der Weise angepaßt, daß die senderseitig erzeugten Signalanteile unterschiedlicher Phasenlage zu einem zeitlich nahezu koinzidenten Signal (annähernden δ-Impuls) überlagert werden.

In einer vorteilhaften Ausführungsform der Erfindung erfolgt die Aufprägung der Informationen des Eingangssignals dadurch, daß die Modulationscharakteristik in Abhängigkeit vom Eingangssignal ausgewählt bzw. verändert wird. Weist das Eingangssignal einen High-Pegel auf, so wird beispielsweise eine mit dem Signal ( am einfachsten linear) fallende Modulationscharakteristik verwendet, was zu einem frequenzmodulierten Impuls mit einer während der Impulsdauer abnehmenden Frequenz ("Down-Chirp") führt. Bei einem Low-Pegel des Eingangssignals wird dagegen eine (linear) steigende Modulationscharakteristik verwendet, was entsprechend zu einem Impuls mit einer während der Impulsdauer zunehmenden Frequenz ("Up-Chirp") führt.

Die empfängerseitigen Filtermittel sind durch eine inverse bzw. komplementäre Kennlinie angepaßt. Erfolgt die senderseitige Winkelmodulation entsprechend einer fallenden Modulationscharakteristik, so nimmt die Frequenz des Impulses während der Impulsdauer ab, was zur Folge hat, daß die höherfrequenten Signalanteile empfängerseitig vor den niederfrequenten Signalanteilen erscheinen. Das Laufzeitverhalten des empfängerseitigen Dispersionsfilters muß diesen "Vorsprung" der höherfrequenten Signalanteile deshalb ausgleichen, damit sich die spektralen Signalanteile des frequenzmodulierten Impulses am Ausgang des Dispersionsfilters zu einem Impuls mit erhöhter Amplitude überlagern.

Es ist möglich, mehr als zwei Modulationscharakteristiken für das Eingangssignal zu verwenden, um mit jedem Impuls einen größeren Informationsanteil zu übertragen. Stehen beispielsweise vier verschiedene Modulationscharakteristiken zur Auswahl, so können entsprechend vier unterschiedliche Impulse übertragen werden, was einer Informationsmenge von jeweils 2 Bit bei jedem übertragenen Impuls entspricht. Durch dErhöhung der Anzahl unterschiedlicher Modulationscharakteristiken läßt sich also vorteilhaft die Datenübertragungsrate steigern, wobei jedoch zu beachten ist, daß zugleich der technische Aufwand ansteigt und die verschiedenen Impulse mit sehr großer Zahl verschiedener Modulationscharakteristiken immer schwieriger zu unterscheiden sind, was die Störanfälligkeit der Übertragung erhöht.

In der vorstehend beschriebenen Variante der Erfindung erfolgt die Modulation der Impulse aktiv sowohl für einen High-Pegel als auch für einen Low-Pegel des digitalen Eingangssignals. Dies bedeutet, daß sowohl bei einem High-Pegel als auch bei einem Low-Pegel des Eingangssignals frequenzmodulierte Impulse erzeugt werden, die sich durch die Art der Frequenzänderung während der Impulsdauer unterscheiden. Die Aufprägung der in dem Eingangssignal enthaltenen Nachricht auf das übertragene Signal erfolgt hierbei also durch die Auswahl bzw. Änderung der Modulationscharakteristik in Abhängigkeit vom Eingangssignal.

Alternativ kann die Übertragung des Eingangssignals bei nur einem von zwei definierten Pegeln aktiv vorgenommen werden, während bei dem anderen Pegel kein Impuls erzeugt wird. So wird beispielsweise bei einem High-Pegel des Eingangssignals ein linear ansteigend frequenzmodulierter Impuls erzeugt, während bei einem Low-Pegel eine Pause mit der Länge eines Impulses eingelegt wird. Diese Variante der Erfindung ermöglicht mit geringem technischen Aufwand eine Realisierung des Verfahrens mit einer einzigen Modulationscharakteristik. Insbesondere ist empfängerseitig auch nur ein Dispersionsfilter erforderlich.

Die Aufprägung der in dem Eingangssignal enthaltenen Nachricht auf das übertragene Signal erfolgt nach einem an sich bekannten digitalen Modulationsverfahren, vorzugsweise durch Pulspositionsmodulation (PPM - auch Pulsabstandsmodulation genannt), bei der die Lage der einzelnen frequenzmodulierten Impulse relativ zu einem Referenzimpuls in Abhängigkeit vom Eingangssignal geändert wird. Auch ein Einsatz der Pulsphasen- oder Pulsbreitenmodulation ist grundsätzlich sinnvoll, erfordert aber ggfs. einen höheren technischen Aufwand oder erreicht nicht alle Vorteile der PPM.

Bei der Kombination der "Chirp"-Modulation zur Träger-Störunterdrückung mit der PPM zur Aufprägung der Nachricht kann in besonders vorteilhafter Weise die mit der Impulskompression auf Impulse mir sehr kurzer Anstiegszeit einhergehende empfängerseitige Erhöhung der Zeitauflösung unter Ausnutzung des Superpositionsprinzips beim Empfang einander zeitlich überlappender Impulse zur Erhöhung der Übertragungsrate (bezogen auf die vergrößerte Bandbreite) genutzt werden. Insgesamt gesehen, gelingt damit eine weitgehende Kompensation der ursprünglichen Einbuße an Übertragungsrate. Ein (geringer) Teil der imfolge der Kompression eingesparten Sendeleistung wird zu Ausendung der für die PPM benötigten Referenzimpulse und ggfs. zusätzlicher Codierungsimpulse im gleichen Kanal eingesetzt.

Die Rückgewinnung der in dem Eingangssignal enthaltenen Nachricht erfolgt durch einen dem Dispersionsfilter nachgeschalteten Detektor, der an das Modulationsverfahren angepaßt ist, das senderseitig zur Aufprägung der in dem Eingangssignal enthaltenen Nachricht verwendet wird.

Wird dagegen senderseitig in Abhängigkeit von der Amplitude des Eingangssignals eine von mehreren Modulationscharakteristiken ausgewählt, vorzugsweise eine linear fallende Modulationscharakteristik bei einem High-Pegel und eine linear steigende Modulationscharakteristik bei einem Low-Pegel des Eingangssignals, so bestehen zur Auswertung im Empfänger grundsätzlich zwei Möglichkeiten.

Eine Möglichkeit besteht darin, empfängerseitig nur ein Dispersionsfilter vorzusehen, dessen differentielles Phasenverzögerungs- bzw. Gruppenlaufzeitverhalten an eine der senderseitig verwendeten Modulationscharakteristiken in der Weise angepaßt ist, daß die Signalanteile des entsprechend dieser Modulationscharakteristik frequenzmodulierten Impulses am Ausgang des Dispersionsfilters überlagert erscheinen, was zu einer Impulskompression und Amplitudenerhöhung führt. Für einen Impuls mit einer der anderen Modulationscharakteristiken, die nicht optimal an das Laufzeitverhalten des empfängerseitigen Dispersionsfilters angepaßt ist, erscheinen die spektralen Signalanteile dagegen zeitlich verteilt am Ausgang des Dispersionsfilters und somit wegen der geringeren Impulskompression auch mit einer geringeren Amplitude. In dieser Ausführungsform hängt die Amplitude des am Ausgang des Dispersionsfilters erscheinenden Impulses also von der senderseitig verwendeten Modulationscharakteristik und damit von der Amplitude des Eingangssignals ab, die zur Auswahl der Modulationscharakteristik herangezogen wird. Um das digitale Eingangssignal aus dem Ausgangssignal des Dispersionsfilters zurückzugewinnen, ist diesem ein amplitudenempfindlicher Detektor nachgeschaltet, der als Amplitudendemodulator ausgeführt sein kann.

Die andere Möglichkeit sieht dagegen vor, den frequenzmodulierten Impuls empfängerseitig mehreren parallelgeschalteten Dispersionsfiltern zuzuführen. Das frequenzabhängige Laufzeitverhalten der empfängerseitig angeordneten Dispersionsfilter und die senderseitig verwendeten Modulationscharakteristiken sind hierbei jeweils paarweise derart aneinander angepaßt, daß die Signalanteile des frequenzmodulierten Impulses am Ausgang genau eines der Dispersionsfilter komprimiert erscheinen und dadurch zu einer Amplitudenerhöhung führen, während die Ausgangssignale der anderen Dispersionsfilter wegen der abweichenden Charakteristik nicht erhöht sind. Das Eingangssignal kann also danach diskriminiert werden, an welchem der Dispersionsfilter eine Amplitudenerhöhung vorliegt.

Die Dispersionsfilter werden vorteilhafterweise als Oberflächenwellenfilter ("SAW-Filter") ausgeführt, die sich mit hoher Genauigkeit und Stabilität herstellen lassen. Darüber hinaus bieten SAW-Filter den Vorteil, daß sich Amplitudengang und Phasengang unabhängig voneinander dimensionieren lassen, was die Möglichkeit eröffnet, das in jedem Empfänger erforderliche schmalbandige Bandpaßfilter und das Dispersionsfilter in einem Bauteil zu verwirklichen.

Die Erzeugung des frequenzmodulierten Signals im Sender kann auf verschiedene Arten erfolgen, von denen beispielhaft einige im folgenden kurz beschrieben werden.

In einer vorteilhaften Variante der Erfindung wird zunächst näherungsweise ein (Quasi-)Dirac-Impuls erzeugt und einem Tiefpaßfilter zugeführt, dessen Filterkennlinie kurz vor Erreichen der Grenzfrequenz eine Überhöhung aufweist und den Stoß-Impuls somit in einen si-Impuls (Spaltimpuls) transformiert, dessen Form durch die bekannte si-Funktion si(x)=^{sinx}/ₓ beschrieben wird. Das si-förmige Ausgangssignal des Tiefpaßfilters wird anschließend auf einen Amplitudenmodulator gegeben, der der Trägerschwingung die si-förmige Hüllkurve aufprägt. Wird das auf diese Weise erzeugte Signal einem dispergierenden Filter zugeführt, so erscheint am Ausgang ein frequenzmodulierter Impuls. In dieser Variante der Erfindung erfolgt also senderseitig zunächst eine Expansion des relativ scharfen si-Impulses durch das Dispersionsfilter in einen frequenzmodulierten Impuls, der gegenüber dem si-Impuls verlängert ist und eine entsprechend geringere Amplitude aufweist. Empfängerseitig erfolgt dann ebenfalls durch ein Dispersionsfilter wieder eine Kompression des Impulses mit einer entsprechenden Amplitudenerhöhung. Da zur senderseitigen Expansion und empfängerseitigen Kompression der Impulse jeweils ein Dispersionsfilter verwendet wird, eignet sich diese Variante der Erfindung vorteilhaft für einen Transceiverbetrieb mit abwechselndem Sende- und Empfangsbetrieb. Hierzu können Sender und Empfänger jeweils korrespondierende baugleiche Baugruppen mit jeweils einem Dispersionsfilter aufweisen, die im Sendebetrieb zur Erzeugung des frequenzmodulierten Impulses und im Empfangsbetrieb zur Kompression der empfangenen frequenzmodulierten Impulse dienen.

Gemäß einer anderen Variante der Erfindung erfolgt die Erzeugung des frequenzmodulierten Impulses dagegen mittels einer PLL-Schleife (PLL: Phase Locked Loop) und einem spannungsgesteuerten Oszillator (VCO: Voltage Controlled Oscillator). Die einzelnen Impulse des in digitaler Form vorliegenden Eingangssignals werden hierzu zunächst in einem Integrator in sägezahnförmige Impulse umgewandelt, wobei die Anstiegsrichtung der einzelnen Impulse von der Amplitude des Eingangssignals abhängt. Das auf diese Weise erzeugte Signal wird dann zur Ansteuerung des VCO's verwendet, so daß die Frequenz eines Ausgangsimpulses während der Impulsdauer in Abhängigkeit vom Pegel des Eingangssignals linear zunimmt oder fällt.

In einer weiteren Variante der Erfindung erfolgt die Erzeugung des frequenzmodulierten Impulses im Sender durch eine digitale Signalverarbeitungseinheit, was vorteilhaft die Realisierung beliebiger Modulationscharakteristiken ermöglicht.

In einer Variante der Erfindung werden zur Realisierung der komplementären Sender-Empfänger-Charakteristik jeweils aneinander angepaßte Sender-Empfänger-Paare hergestellt, so daß bei der Inbetriebnahme keine weiteren Abstimmarbeiten erforderlich sind.

In einer anderen Variante der Erfindung wird der Empfänger dagegen vor oder während des Betriebs durch Veränderung des Laufzeitverhaltens des empfängerseitig verwendeten Dispersionsfilters an den Sender angepaßt. Hierfür ist vorgesehen, daß der Sender im Rahmen eines Anpassungsvorgangs ein Referenzsignal erzeugt, das vorzugsweise einer Folge von High-Pegeln des Eingangssignals entspricht, wobei die Modulationscharakteristik der senderseitig vorgenommenen Frequenzmodulation oder das frequenzabhängige Laufzeitverhalten des empfängerseitigen Dispersionsfilters so lange verändert wird, bis empfängerseitig eine optimale Impulskompression bzw. Amplitudenerhöhung auftritt. Besonders vorteilhaft ist diese Variante bei der Verwendung eines digitalen Signalprozessors zur Filterung und Aufbereitung im Empfänger, da ein derartiger Signalprozessor in einfacher Weise eine Änderung des frequenzabhängigen Laufzeitverhaltens und eine entsprechende Optimierung ermöglicht, wobei der Optimierungsvorgang rechnergesteuert automatisch ablaufen kann.

In einer weiteren vorteilhaften Ausführungsform dieser Variante erfolgt die Datenübertragung blockweise, wobei der vorstehend beschriebene Anpassungsvorgang bei jedem Block erneut durchgeführt wird, um Schwankungen der Dispersionseigenschaften der Übertragungsstrecke dynamisch ausgleichen zu können.

Vorteilhafte Weiterbildungen der Erfindung sind im übrigen in den Unteransprüchen gekennzeichnet bzw. werden nachstehend zusammen mit der Beschreibung der bevorzugten Ausführung der Erfindung anhand der Figuren näher dargestellt. Es zeigen:
- Figur 1a, 1b: als bevorzugtes Ausführungsbeispiel der Erfindung einen Sender bzw. einen Empfänger eines Nachrichtenübertragungssystems als Blockschaltbild,
- Figur 2a bis 2e: das digitale Eingangssignal des Senders sowie verschiedene Zwischenstadien der Signalverarbeitung im Sender bis zum Sendesignal sowie
- Figur 3a bis 3d: das Empfangssignal sowie verschiedene Zwischenstadien der Signalverarbeitung im Empfänger bis zum demodulierten Signal,
- Figur 4a, 4b: Sender bzw. Empfänger eines Nachrichtenübertragungssystems mit aktiver Übertragung von High- und Low-Pegel in einer Darstellung als Blockschaltbild,
- Figur 5a bis 5k: : das digitale Eingangssignal des Senders in Figur 4a sowie verschiedene Zwischenstadien der Signalverarbeitung im Sender,
- Figur 6a bis 6e: das empfängerseitig aufgenommene Signal sowie mehrere Zwischenstadien der Signalverarbeitung im Empfänger,
- Figur 7, 8: jeweils eine abgewandelte Form des in Figur 4b dargestellten Empfängers mit einer Rauschunterdrückungsschaltung und
- Figur 9a und 9b: grafische Darstellungen zur mit dem erfindungegemäßen Verfahren erzielbaren Verbesserung des Signal/Rausch-Verhältnisses.

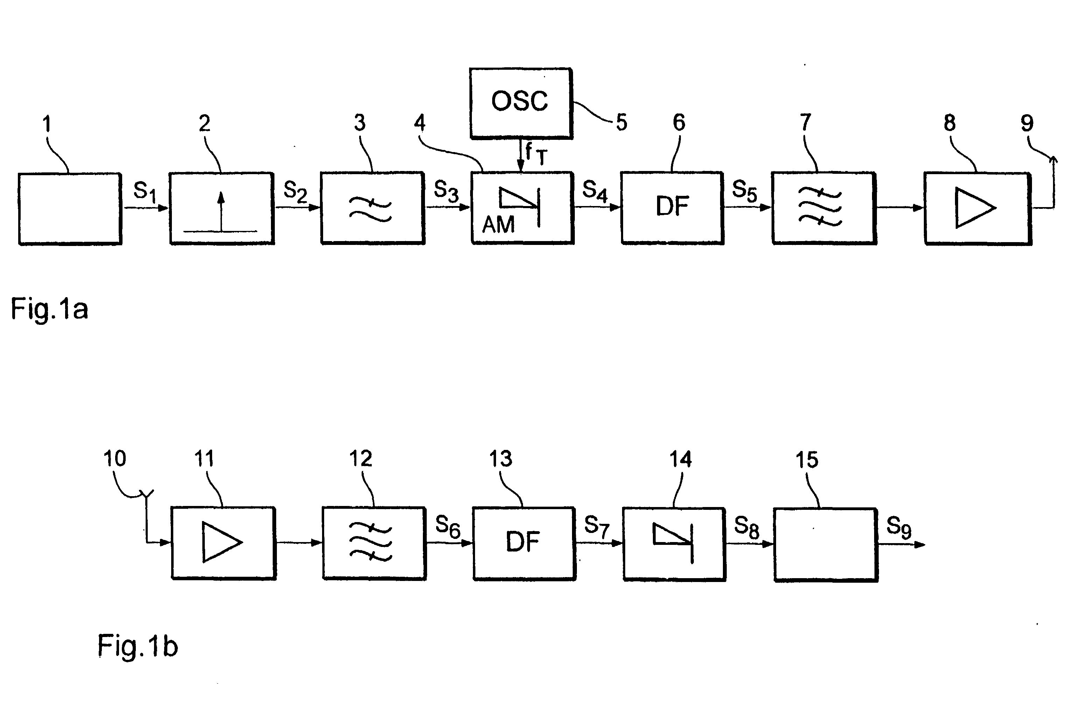

Ein in Figur 1a dargestellter Sender dient zur Übertragung des von einer Signalquelle 1 erzeugten und in digitalisierter Form vorliegenden Signals s₁ über eine störungsbehaftete Übertragungsstrecke an den in Figur 1b dargestellten Empfänger, wobei die Übertragung bei vorgegebenen Anforderungen an Reichweite und Störsicherheit vorteilhaft mit einer relativ geringen Sendeleistung erfolgen kann, was zum einen bei einem Batteriebetrieb des Senders die Batterielebensdauer erhöht und zum anderen die Umweltbelastung durch elektromagnetische Strahlung - auch als Elektro-Smog bezeichnet - verringert. Darüber hinaus weist der Sender aufgrund der relativ geringen Sendeleistung ein verringertes Störpotential anderen Nachrichtenübertragungssystemen gegenüber auf.

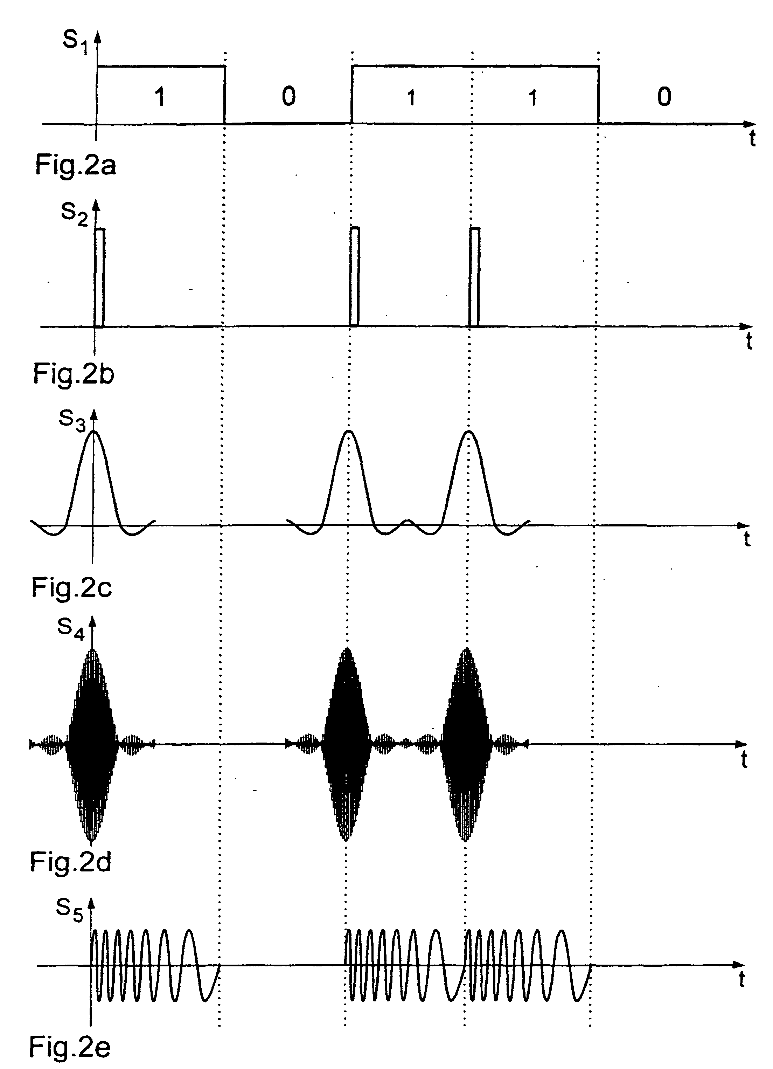

Ein digitales Eingangssignal s₁, dessen zeitlicher Verlauf in Figur 2a detailliert dargestellt ist, wird im Sender zunächst einem Pulsformer 2 zugeführt, der die relativ breiten Rechteckimpulse des Eingangssignals s₁ in kurze Nadelimpulse transformiert, die (quasi-)Dirac-Impulse nachbilden sollen. Aus der Darstellung der Nadelimpulsfolge s₂ in Figur 2b ist ersichtlich, daß die Erzeugung der einzelnen Nadelimpulse jeweils durch die steigende Flanke eines Rechteckimpulses des Eingangssignals s₁ getriggert wird.

Ein auf diese Weise erzeugte Nadelimpulsfolge s₂ wird anschließend einem Tiefpaßfilter 3 zugeführt, dessen Laufzeitverhalten kurz vor der Grenzfrequenz eine Überhöhung aufweist, so daß die einzelnen Nadelimpulse - wie aus Figur 2c ersichtlich - jeweils in si-Impulse transformiert werden, deren Form der bekannten si-Funktion (Spaltfunktion) si(x)=^{sin x}/ₓ entspricht.

Im Anschluß daran wird die si-Impulsfolge s₃ einem Amplitudenmodulator 4 zugeführt, der dieses Signal auf eine Trägerschwingung der Frequenz f_{T} aufmoduliert, die von dem Oszillator 5 erzeugt wird, so daß am Ausgang des Amplitudenmodulators 4 - wie in Figur 2d dargestellt - Trägerfrequenzimpulse mit einer si-förmigen Hüllkurve erzeugt werden. (Die Impulse sind in der Zeichnung aus darstellungstechnischen Gründen verbreitert dargestellt, sind also - bei maßstäblicher Darstellung - tatsächlich schmaler.)

Dem Amplitudenmodulator 4 ist ein Dispersionsfilter 6 nachgeschaltet, welches das modulierte Trägerfrequenzsignal s₄ entsprechend seiner frequenzabhängigen differentiellen Laufzeitcharakteristiken filtert. Am Ausgang des Dispersionsfilters 6 erscheinen deshalb - wie aus Figur 2e ersichtlich - linear frequenzmodulierte Impulse mit konstanter Amplitude, deren Frequenz während der Impulsdauer von einem oberhalb der Trägerfrequenz f_{T} liegenden Wert f_{T}+Δf/2 auf einen unterhalb der Trägerfrequenz f_{T} liegenden Wert f_{T}-Δf/2 abfällt.

Bei dem hier dargestellten Sender erfolgt die Übertragung des Eingangssignals s₁ also unipolar, d.h. es wird lediglich bei einem High-Pegel des Eingangssignals s₁ ein Sendeimpuls erzeugt, während ein Low-Pegel an einer Pause des Sendesignals s₅ erkennbar ist. Aus diesem Grund lassen sich Sender und Empfänger vorteilhaft relativ einfach mit jeweils nur einem Dispersionsfilter 6 bzw. 13 aufbauen.

Die auf diese Weise erzeugte Impulsfolge s₅ wird nachfolgend einem Bandpaßfilter 7 zugeführt, dessen Mittenfrequenz gleich der Trägerfrequenz f_{T} der frequenzmodulierten Impulse ist, so daß außerhalb des Übertragungsbandes liegende Signale ausgefiltert werden.

Das bandpaßbegrenzte Signal wird schließlich über einen Sendeverstärker 8 der Antenne 9 zugeführt und abgestrahlt.

Der in Figur 1b dargestellte Empfänger ermöglicht den Empfang des von dem vorstehend beschriebenen Sender abgestrahlten linear frequenzmodulierten Signals sowie die Demodulation und Rückgewinnung des digitalen Eingangssignals s₃ bzw. s₁.

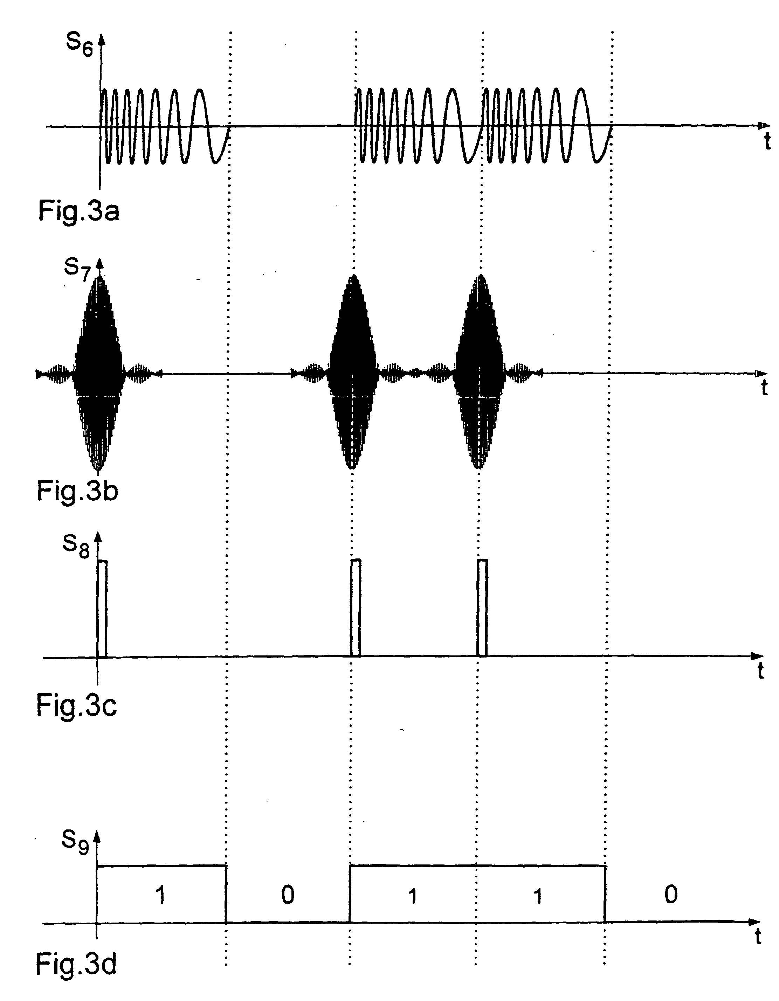

Hierzu wird bei dem vorliegenden Ausführungsbeispiel das über die Empfängerantenne 10 - beispielsweise auch im Diversity-Betrieb - empfangene Signal zunächst einem Vorverstärker 11 und nachfolgend einem Bandpaßfilter 12 zugeführt, dessen Mittenfrequenz gleich der Trägerfrequenz f_{T} des bandpaßbegrenzten Sendesignals ist, so daß Störsignale aus anderen Frequenzbereichen aus dem empfangenen Signal ausgefiltert werden. (Anstelle eines konventionellen Bandpaßfilters kann hier auch vorteilhafterweise ein SAW-Filter verwendet werden.) Der zeitliche Verlauf des auf diese Weise aufbereiteten Signals s₆ ist detailliert in Figur 3a dargestellt, wobei zur Vereinfachung eine störungsfreie Übertragungsstrecke angenommen wird.

Das empfangene Signal s₆ besteht also aus einer Folge von linear frequenzmodulierten Impulsen, wobei die Frequenz entsprechend der senderseitig verwendeten Modulationscharakteristik während der Impulsdauer linear von einem oberhalb der Trägerfrequenz liegenden Wert f_{T}+Δf auf einen unterhalb der Trägerfrequenz f_{T} liegenden Wert f_{T}-Δf abfällt.

Das Signal s₆ wird anschießend einem Dispersionsfilter 13 zugeführt, das die einzelnen Impulse des Eingangssignals s₆ zeitlich komprimiert, was zu einer entsprechenden Amplitudenerhöhung und damit einem verbesserten Signal/Rauschabstand führt.

Die Impulskompression nutzt hierbei die Tatsache, daß die höherfrequenten Signalanteile der Impulse aufgrund der senderseitig durchgeführten linearen Frequenzmodulation am Eingang des Dispersionsfilters 13 vor den niederfrequenten Signalanteilen erscheinen. Das Dispersionsfilter 13 gleicht deshalb den "Vorsprung" der höherfrequenten Signalanteile aus, indem diese in dem Dispersionsfilter stärker verzögert werden als die niederfrequenten Signalanteile. Das frequenzabhängige differentielle Laufzeitverhalten des Dispersionsfilters 13 ist hierbei derart an die Modulationscharakteristik der senderseitig durchgeführten Frequenzmodulation angepaßt, daß die spektralen Signalanteile des empfangenen Signals im wesentlichen koinzident am Ausgang des Dispersionsfilters 13 erscheinen und sich somit - wie aus Figur 3b ersichtlich - zu einem Signal s₇ mit jeweils impulsweise si-förmiger Hüllkurve überlagern, wobei die Amplitude der einzelnen Impulse gegenüber dem empfangenen linear frequenzmodulierten Signal s₆ wesentlich vergrößert ist. (An dieser Stelle ist darauf hinzuweisen, daß bei den in den Figuren dargestellten prinzipiellen Signaldarstellungen zur Vergrößerung der Deutlichkeit eine Verzerrung vorgenommen wurde. Die linear frequenzmodulierten Impulse sind in der Realität im Verlauf enger und die komprimierten Signale sehr viel schmaler.

Das Ausgangssignal des Dispersionsfilters 13 wird dann einem Demodulator 14 zugeführt, der das Signal s₇ von der hochfrequenten Trägerschwingung befreit und - wie aus Figur 3c ersichtlich - ein diskretes Ausgangssignal s₈ mit nadelförmigen Impulsen erzeugt.

Im Anschluß daran wird aus den nadelförmigen Impulsen mittels eines Impulsformers 15 das ursprüngliche digitale Signal s₉ zurückgewonnen, dessen zeitlicher Verlauf detailliert in Figur 3d dargestellt ist.

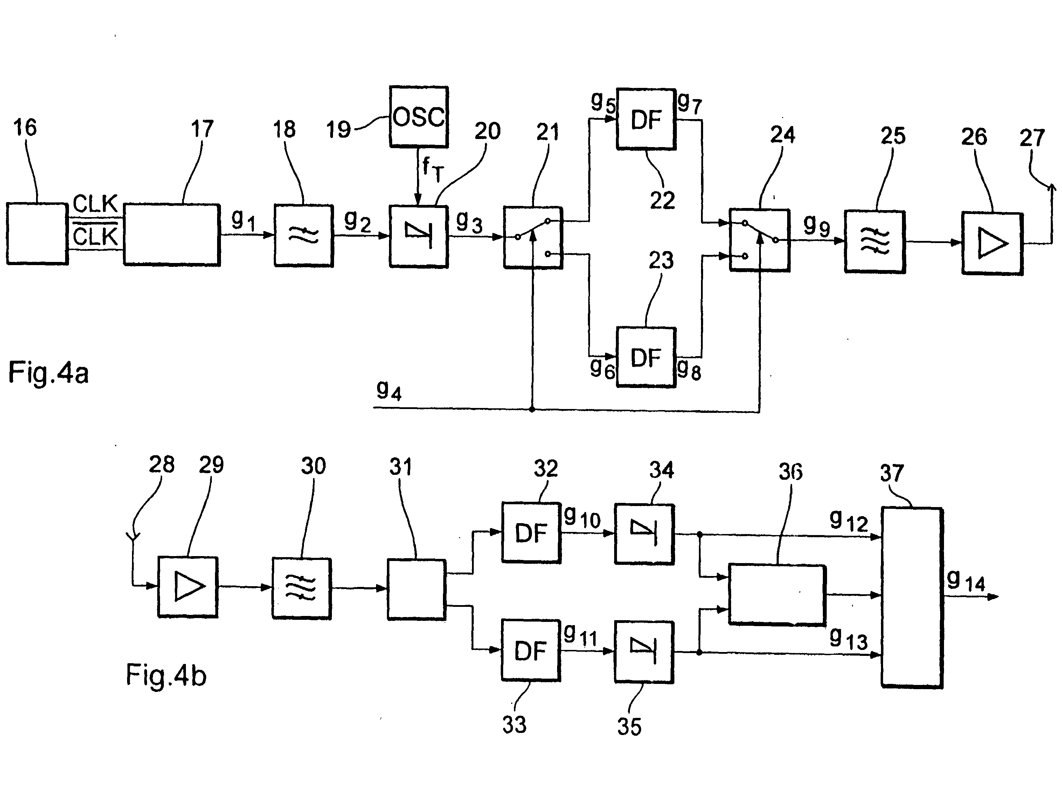

In den Figuren 4a und 4b ist ein weiteres erfindungsgemäß ausgestaltetes Nachrichtenübertragungssystem dargestellt, das sich von dem vorstehend beschriebenen einfacheren Ausführungsbeispiel im wesentlichen dadurch unterscheidet, daß sowohl der High-Pegel als auch der Low-Pegel des digitalen Nachrichtensignals aktiv übertragen wird, was zu einer erhöhten Störsicherheit beiträgt.

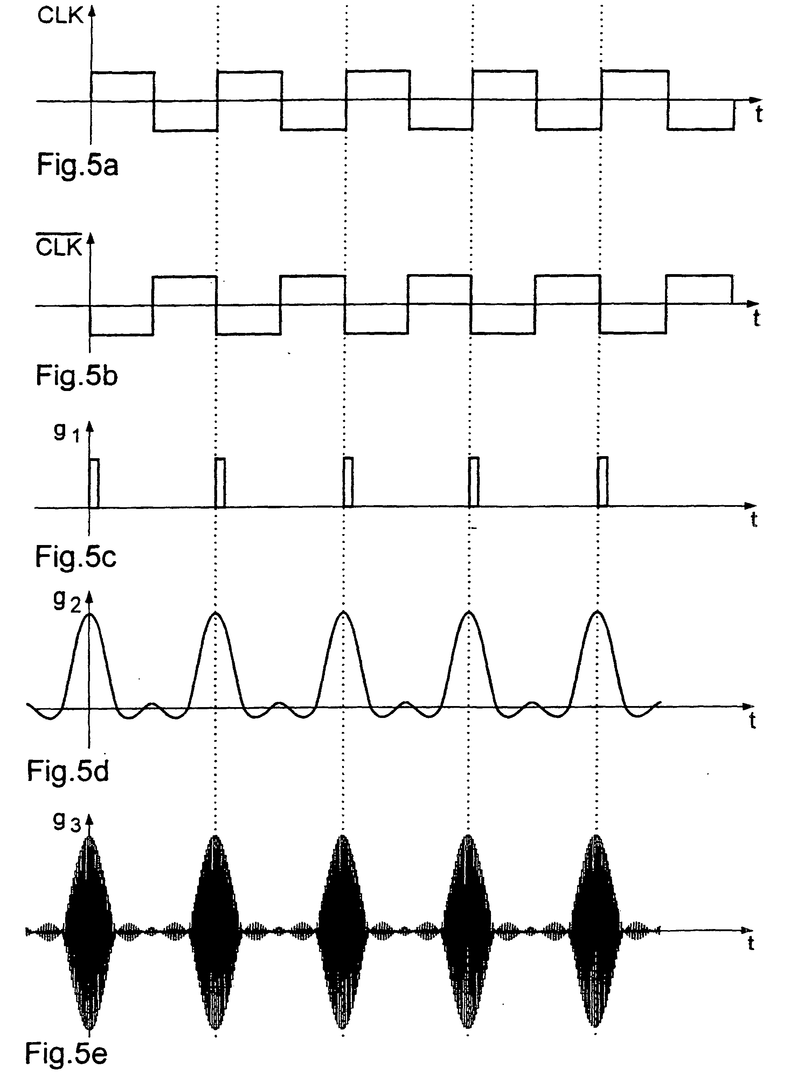

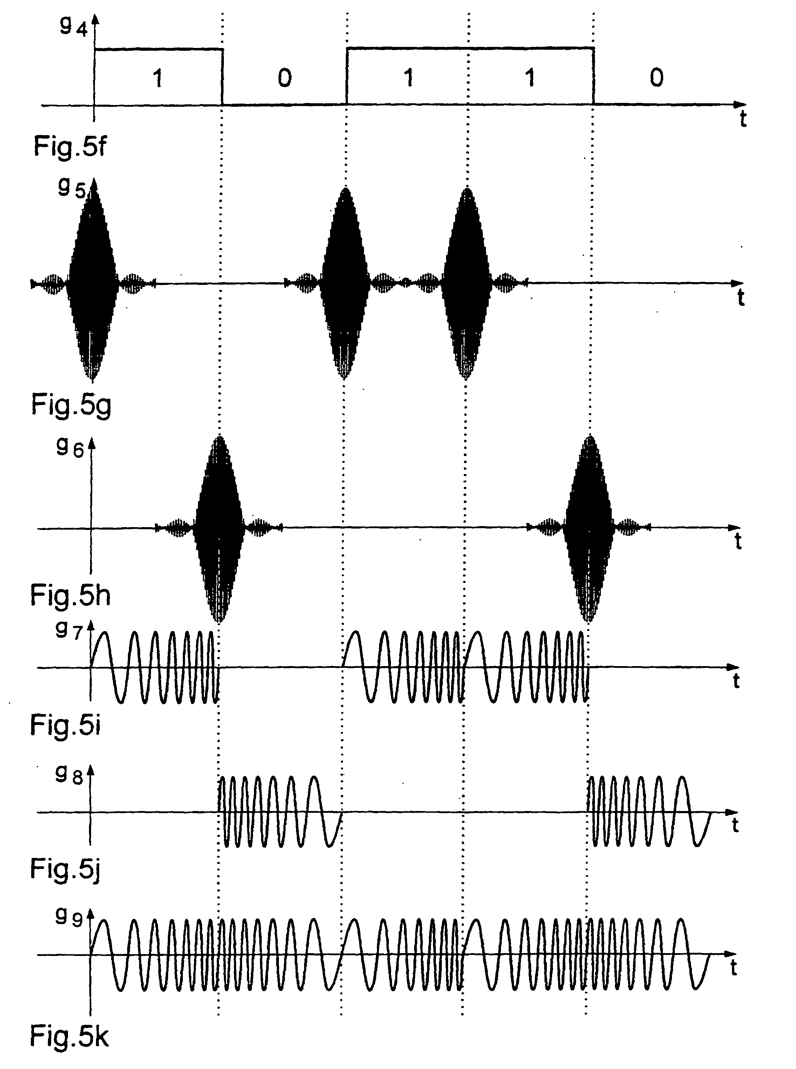

Der in Figur 4a dargestellte Sender weist hierzu einen Pulsformer 17 auf, der von einem Taktgeber 16 mit den in Figur 5a bzw. 5b dargestellten gegenphasigen Taktsignalen angesteuert wird und an seinem Ausgang - wie in Figur 5c dargestellt - eine Folge g₁ von nadelförmigen Impulsen ausgibt, die eine (Quasi-)Dirac-Stoß-Folge nachbilden. Die auf diese Weise erzeugte Impulsfolge g₁ wird anschließend einem Tiefpaßfilter 18 zugeführt, dessen Filterkennlinie kurz vor der Grenzfrequenz eine Überhöhung aufweist und die nadelförmigen Impulse jeweils in si-förmige Impulse (Spaltimpulse) transformiert, die detailliert in Figur 5d dargestellt sind. Nachfolgend wird diese Impulsfolge g₂ mittels eines Amplitudenmodulators 20 auf eine von dem Oszillator 19 erzeugte Trägerschwingung mit der Trägerfrequenz f_{T} aufmoduliert. Am Ausgang des Amplitudenmodulators 20 erscheint somit eine Folge g₃ von äquidistanten Trägerfrequenzimpulsen mit jeweils si-förmiger Hüllkurve. Wichtig ist in diesem Zusammenhang, daß die am Ausgang des Amplitudenmodulators 20 erscheinende Impulsfolge g₃ unabhängig von dem digitalen Eingangssignal g₄ ist und somit keine Information trägt.

Die Aufprägung der Information des Eingangssignals g₄ erfolgt anschließend mittels eines Analog-Schalters 21, der von dem Eingangssignal g₄ angesteuert wird und die von dem Amplitudenmodulator 20 erzeugte Impulsfolge g₃ in Abhängigkeit von der Amplitude des Eingangssignals g₄ entweder einem Dispersionsfilter 22 mit einer frequenzabhängig linear fallenden Laufzeit oder einem Dispersionsfilter 23 mit einer frequenzabhängig linear steigenden Laufzeit zuführt. Ausgangsseitig sind die beiden Dispersionsfilter 22, 23 mit einem weiteren Analog-Schalter 24 oder einer Summierstufe verbunden, der in Abhängigkeit von der Amplitude des Eingangssignals g₄ das Ausgangssignal g₇ bzw. g₈ eines der beiden Dispersionsfilter 22, 23 auswählt und weiterleitet.

Am Ausgang des Analog-Schalters 24 erscheint somit - wie in Figur 5k dargestellt - eine Folge g₉ von jeweils impulsweise linear frequenzmodulierten Trägerfrequenzimpulsen, wobei die einzelnen Impulse bei einem High-Pegel des Eingangssignals g₄ innerhalb der Impulsdauer eine linear zunehmende Frequenz aufweisen, wohingegen bei einem Low-Pegel des Eingangssignals g₄ die Frequenz innerhalb eines Impulses linear abnimmt.

Das am Ausgang des Analog-Schalters 24 erscheinende Signal wird anschließend von einem Bandpaßfilter 25 gefiltert, um außerhalb des Übertragungsbandes liegende Störsignale zu unterdrücken. Das auf diese Weise gewonnene Signal wird dann von einem Sendeverstärker 26 verstärkt und über die Sendeantenne 27 abgestrahlt.

Figur 4b zeigt den zugehörigen Empfänger, der das von dem in Figur 4a dargestellten Sender abgestrahlte Signal über eine Antenne 28 empfängt und zunächst in einem Vorverstärker 29 verstärkt und in einem Bandpaßfilter 30 von solchen Störsignalen befreit, deren Frequenz außerhalb des Übertragungsbandes liegt.

Anschließend wird das empfangene Signal über ein Koppelelement 31 zwei Dispersionsfiltern 32, 33 zugeführt. Das frequenzabhängige Laufzeitverhalten der beiden empfängerseitigen Dispersionsfilter 32, 33 ist hierbei jeweils paarweise an das frequenzabhängige Laufzeitverhalten der beiden senderseitig angeordneten Dispersionsfilter 22, 23 in der Weise angepaßt, daß sich die spektralen Signalanteile des empfangenen Signals am Ausgang eines der beiden Dispersionsfilter 32 bzw. 33 zu einem Impuls mit erhöhter Amplitude addieren, während am Ausgang des anderen Dispersionsfilters 33 bzw. 32 ein zeitlich expandierter Impuls erscheint.

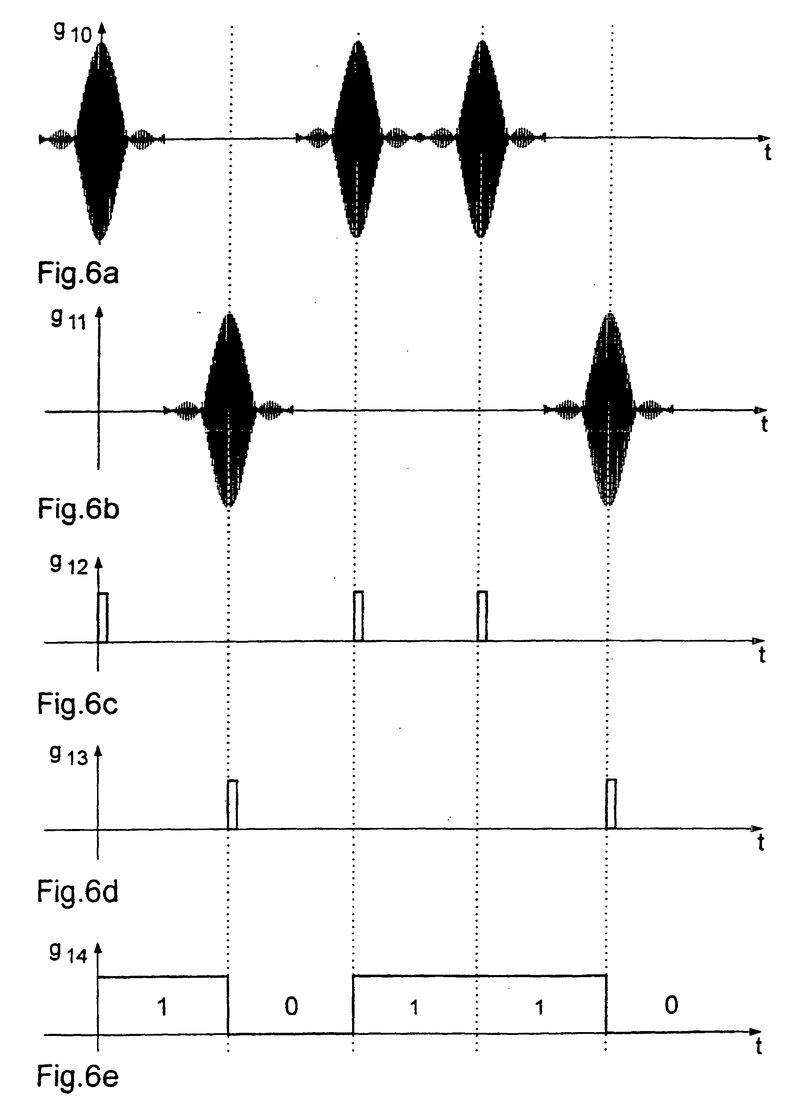

Aus den Figuren 6a und 6b ist ersichtlich, daß die Ausgangssignale g₁₀ bzw. g₁₁ der Dispersionsfilter 32, 33 jeweils aus einer Folge von Trägerfrequenzimpulsen mit einer si-förmigen Hüllkurve bestehen.

Die am Ausgang der beiden Dispersionsfilter 32, 33 erscheinenden Signale g₁₀ bzw. g₁₁ werden anschließend jeweils einem Demodulator 34, 35 zugeführt, der die Signale g₁₀ bzw. g₁₁ von der Trägerschwingung befreit und jeweils nadelförmige Impulse erzeugt, wie aus Figur 6c bzw. 6d ersichtlich.

Während die Nadelimpulse am Ausgang des einen Demodulators 34 jeweils einem High-Pegel des Eingangssignals g₄ entsprechend, kennzeichnen die am Ausgang des anderen Demodulators 35 erscheinenden Nadelimpulse jeweils einen Low-Pegel des Eingangssignals g₄.

Um aus diesen beiden Signalen g₁₂, g₁₃ das ursprüngliche Eingangssignal g₄ zurückzugewinnen, werden die beiden Signale g₁₂, g₁₃ zur Triggerung einem Taktgeber 36 zugeführt, der ein Taktsignal erzeugt, welches die Taktrate des ursprünglichen Eingangssignals g₄ wiedergibt. Dieses Taktsignal wird zusammen mit den Ausgangssignalen g₁₂, g₁₃ der beiden Demodulatoren 34, 35 dem Dekoder 37 zugeführt, der das ursprüngliche Ausgangssignale g₄ bzw. g₁₄ zurückgewinnt, wie aus Figur 6e ersichtlich ist.

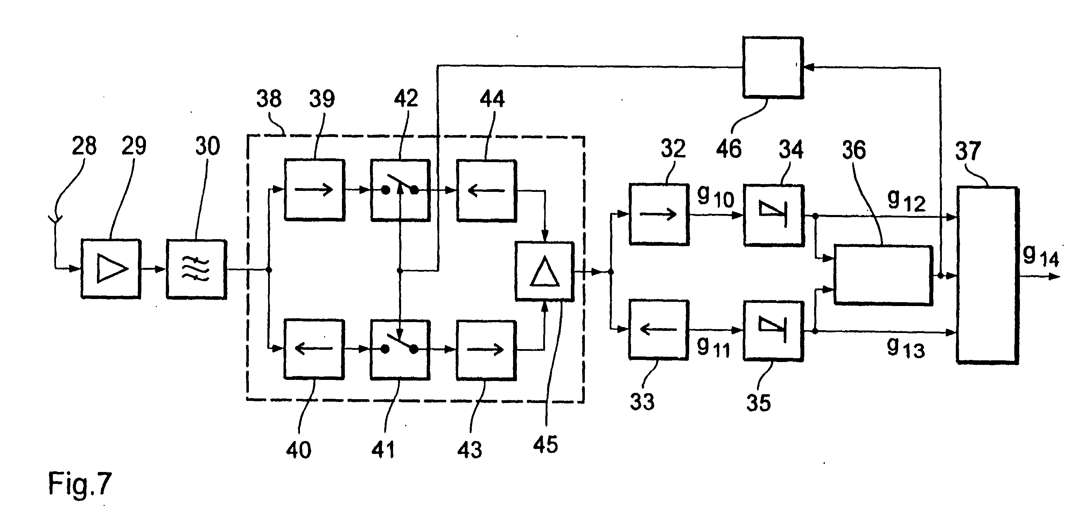

Figur 7 zeigt eine abgewandelte Form des in Figur 4b dargestellten Empfängers mit einer Rauschunterdrückungsschaltung 38, die auch mit anderen Empfängern für derartige Chirp-Signale kombiniert werden kann. Wegen der weitgehenden Übereinstimmung dieses Empfängers mit dem in Figur 4b dargestellten Empfänger sind funktionsgleiche Bauelemente in beiden Figuren mit denselben Bezugszeichen versehen.

Wie bei dem bereits vorstehend beschriebenen Empfänger wird das senderseitig gechirpte Signal über die Antenne 15 aufgenommen und zunächst einem Eingangsverstärker 29 sowie einem Bandpaßfilter 30 zugeführt, das auf die Trägerfrequenz abgestimmt ist und somit außerhalb des Übertragungsbandes liegende Störsignale ausfiltert. Anschließend wird das Signal der Rauschunterdrückungsschaltung 38 zugeführt und von dieser zunächst auf zwei parallele Zweige aufgeteilt, in denen jeweils zwei zueinander inverse Dispersionsfilter 39, 44 bzw. 40, 43 in Reihe geschaltet sind. Bei einer aktiven Übertragung sowohl eines logischen LOW-Pegels als auch eines logischen HIGH-Pegels ist also eines der beiden eingangsseitig angeordneten Dispersionsfilter 39 bzw. 40 derart angepaßt, daß am Ausgang dieses Dispersionsfilters 39 bzw. 40 ein zeitlich komprimierter Impuls erscheint. Am Ausgang des anderen Dispersionsfilters 39 bzw. 40 erscheint dagegen ein auf die doppelte Länge zeitlich expandierter Impuls. Die beiden Analogschalter 41, 42 unterbrechen jedoch den Signalfluß in den beiden Zweigen symmetrisch um die Mitte des komprimierten Impulses, so daß der zeitlich komprimierte Impuls unterdrückt wird und lediglich der zeitlich expandierte Impuls im anderen Zweig übrig bleibt. Die Ansteuerung der Analogschalter 41, 42 erfolgt hierbei durch die Synchronsierungsschaltung 46, die von dem Taktgeber 36 angesteuert wird und somit den Takt des Ausgangssignals und damit den Übertragungstakt vorgibt. Die nachfolgenden Dispersionsfilter 43, 44 erzeugen aus dem zeitlich expandierten Impuls dann wieder den ursprünglichen Impuls mit der ursprünglichen Länge und entsprechend auch mit der ursprünglichen Amplitude. Diese Impulse werden dann auf den Subtrahierer 45 geleitet, an dessen Ausgang somit im wesentlichen der ursprüngliche Impuls erscheint.

Anders liegen die Verhältnisse dagegen bei dem Rauschen, das durch die störungsbehaftete Übertragungsstrecke verursacht wird und zusammen mit dem Nutzsignal vom Empfänger aufgenommen wird. Dieses Rauschen wird zunächst durch die Dispersionsfilter 39, 40 in unterschiedlicher Richtung verschoben. Die nachgeschalteten Dispersionsfilter 43, 44 machen diese Verschiebung jedoch wieder rückgängig, so daß das Eingangsrauschen in den beiden Zweigen bis auf den sehr kurzen, von den Analogschaltern 41, 42 ausgeschnittenen Teil rekonstruiert wird. Die Differenzbildung durch den Subtrahierer 45 führt deshalb zu einer nahezu weitgehenden Unterdrückung des empfängerseitig aufgenommenen Rauschens.

Die weitere Verarbeitung des derart aufbereiteten Signals erfolgt dann wie in der Beschreibung zu Figur 4b ausgeführt.

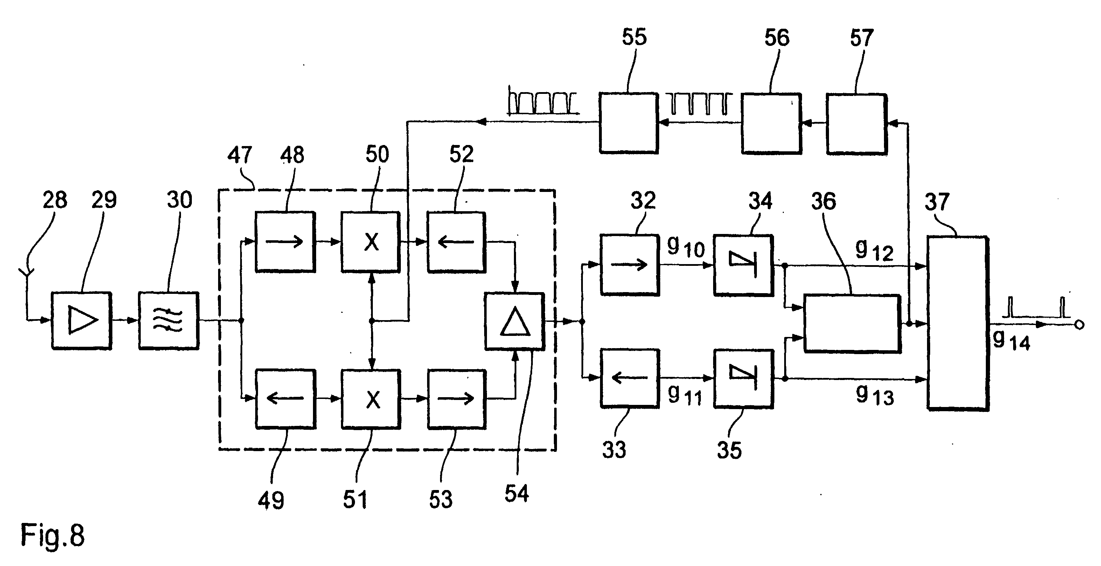

Der in Figur 8 dargestellte Empfänger unterscheidet sich von dem vorstehend beschriebenen und in Figur 7 dargestellten Empfänger im wesentlichen durch den Aufbau und die Ansteuerung der Rauschunterdrückungsschaltung 47. Wegen der somit vorhanden weitgehenden Übereinstimmung der beiden Schaltungen sind funktionsgleiche Bauelemente bzw. Baugruppen in Figur 7 und 8 durch dieselben Bezugszeichen gekennzeichnet.

Wie auch bei dem in Figur 7 dargestellten Empfänger werden die gechirpten Impulse über die Antenne 28 aufgenommen und zunächst einem Eingangsverstärker 29 und einem Bandpaßfilter 30 zugeführt, das auf die Trägerfrequenz abgestimmt ist und somit außerhalb des Übertragungsbandes liegende Störsignale ausfiltert.

Anschließend wird das Signal der Rauschunterdrückungsschaltung 47 zugeführt, die das Signal zunächst auf zwei parallele Zweige aufteilt, in denen jeweils zwei zueinander inverse Dispersionsfilter 48, 52 bzw. 49, 53 in Reihe geschaltet angeordnet sind. Am Ausgang der Rauschunterdrükkungsschaltung 47 werden die beiden Zweige von dem Subtrahierer 54 zusammengeführt, wodurch das Rauschen in dem empfangenen Signal aufgrund der Differenzbildung nahezu vollständig unterdrückt wird.

Im Gegensatz dazu wird das gechirpte Signal durch die Differenzbildung im Subtrahierer 54 nicht aufgehoben, so daß sich der Signal/Rauschabstand wesentlich erhöht. Die eingangsseitig angeordneten Dispersionsfilter 48, 49 sind hierbei derart an die senderseitig erzeugten gechirpten Signale angepaßt, daß am Ausgang einer der Dispersionsfilter 48, 49 ein zeitlich komprimierter Impuls mit entsprechend erhöhter Amplitude erscheint, während am Ausgang des anderen Dispersionsfilters 49, 48 ein zeitlich expandierter Impuls mit entsprechend verringerter Amplitude erscheint. Der Signalfluß in den beiden Zweigen wird nun jeweils beim Erscheinen des komprimierten Impulses - wie noch detailliert beschrieben wird - durch die Multiplizierer 50, 51 synchron unterbrochen, so daß der komprimierte Impuls unterdrückt wird und lediglich der zeitlich expandierte Impuls bis auf die vernachlässigbare kurzfristige Ausschneidung erhalten bleibt. Durch die nachgeschalteten Dispersionsfilter 52, 53 wird dann aus dem zeitlich expandierten Impuls wieder der ursprüngliche Impuls erzeugt, so daß am Ausgang des Subtrahierers 54 im wesentlichen das ursprünglich empfangene Signal mit einem wesentlich verbesserten Signal/Rauschabstand erscheint.

Die Ansteuerung der Multiplizierer 50, 51 erfolgt in fester Synchronisation zum Übertragungstakt, um das Signal in den beiden Zweigen der Rauschunterdrückungsschaltung 47 jeweils exakt beim Erscheinen des zeitlich komprimierten Impuls unterdrücken zu können. Hierzu weist der Empfänger eine Synchronisationsschaltung 57 auf, die eingangsseitig zur Synchronisation mit dem Taktgeber 36 verbunden ist. Über einen nachgeschalteten Pulsformer 56 und ein Tiefpaßfilter 55 werden dann invertierte, mit der Spitze zu Null liegende Spaltimpulse mit der Amplitude 1 erzeugt, die den Multiplizierern 50, 51 zugeführt werden. Die Multiplizierer 50, 51 multiplizieren die Signale in den beiden Zweigen der Rauschunterdrückungsschaltung 47 also entweder mit Null oder mit Eins, was entsprechend entweder zu einer Unterdrückung des Signals führt oder das Signal im wesentlichen unverändert passieren läßt. Die Multiplizierer 50, 51 haben hier also die gleiche Wirkung wie die Schaltelemente 41, 42 in der zuvor beschriebenen Variante der Rauschunterdrükkungsschaltung 38.

Die Erfindung beschränkt sich in ihrer Ausführung nicht auf die vorstehend angegebenen bevorzugten Ausführungsbeispiele. Vielmehr ist eine Anzahl von Varianten möglich, welche von der dargestellten Lösung auch bei grundsätzlich anders gearteten Ausführungen Gebrauch macht. Die hier dargestellten Ausführungsbeispiele sind dabei lediglich als Grundformen eines breiten Spektrums von Lösungen anzusehen.

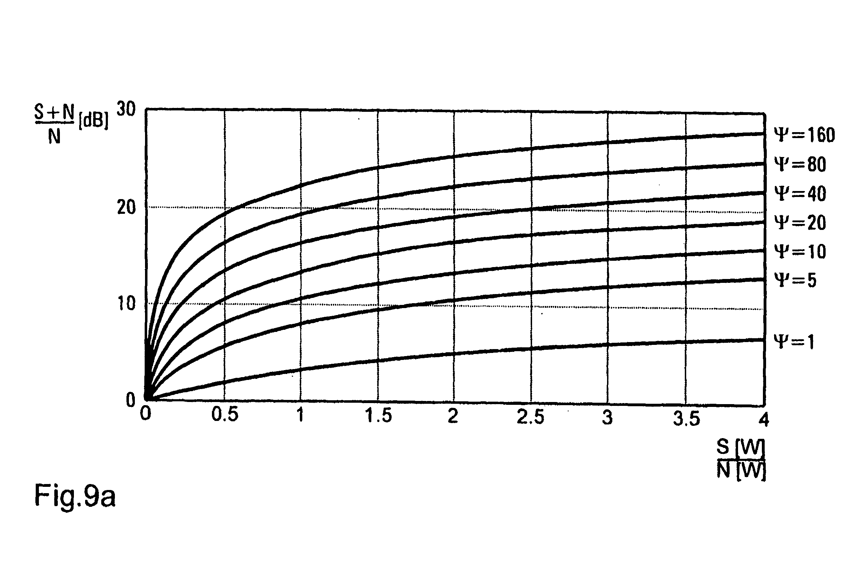

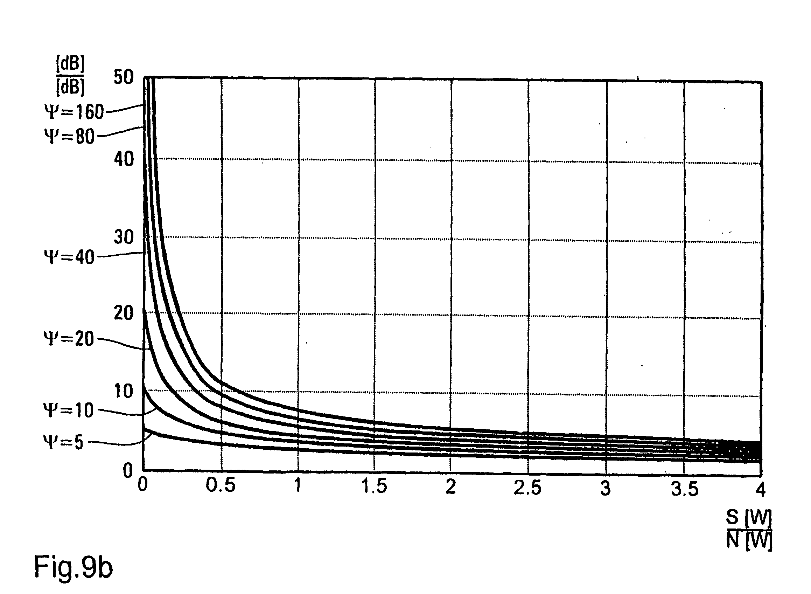

Die Figuren 9a und 9b illustrieren die mit der Erfindung erzielbare Verbesserung des Signal/Rausch-Verhältnisses für verschiedene Dehnungsfaktoren ψ = T_{T}/δ mit T_{T} als mittlerer Zeitdauer eines mittels des "Chirp"-Verfahrens bearbeiteten Sendeimpulses und δ als mittlerer Zeitdauer des im Empfänger komprimierten Impulses. Fig. 9a stellt die Abhängigkeit des Signal/Rausch-Verhältnisses (S+N)/N am Empfängerausgang von S/N am Empfängereingang und Fig. 9b die Abhängigkeit der auf ψ = 1 normierten Abhängigkeiten (S+N)/N = f(S/N) - d.h. den Grad der Verbesserung in Abhängigkeit vom ursprünglichen Signal/Rausch-Verhältnis - dar, wobei für ψ jeweils Werte im Bereich von 1 bis 160 als Parameter gewählt sind.

Die Figuren verdeutlichen, daß die erreichbare Verbesserung mit zunehmender Impuls"dehnung"/-kompression größer wird und für kleine ursprüngliche Signal/Rauschabstände besonders deutlich ausfällt. Dies dokumentiert nachdrücklich, daß das Verfahren besonders in stark gestörten Umgebungen und/oder bei großen Übertragungsreichweiten und/oder für geringe Sendeleistungen vorteilhaft einsetzbar ist.

## Patentansprüche

1. Verfahren zur drahtlosen Übertragung einer Nachricht,. insbesondere für die mobile Kommunikation, bei dem ein Eingangssignal (s₁, g₄) in einem Sender (2 bis 8; 16 bis 26) einer Modulation unterworfen wird und über einen Übertragungskanal zu einem Empfänger (11 bis 15; 29 bis 57) gelangt, wobei
im Sender die Nachricht tragende, ein Frequenzspektrum aufweisende, winkelmodulierte Impulse derart erzeugt werden, daß diese im Empfänger mittels eines Filters (13, 32, 33) mit frequenzabhängiger differentieller Laufzeit, auch Gruppenlaufzeit genannt, derart zeitlich komprimierbar sind, daß Impulse mit gegenüber den ausgesandten Impulsen verkürzter Dauer und erhöhter Amplitude entstehen, und
mindestens ein Teil der Nachricht im Sender mittels einer weiteren, von der Winkelmodulation unabhängigen Modulation den Impulsen aufgeprägt und/oder zur Steuerung eines im Empfänger erfaßbaren Parameters der Winkelmodulation benutzt wird,
**dadurch gekennzeichnet,**
**daß** zur Anpassung von Sender (2 bis 8, 16 bis 26) und Empfänger (11 bis 15, 29 bis 37) während eines Anpassungsvorgangs zum Abgleich ein vorgegebenes digitales Referenzsignal als Eingangssignal (s₁, g₄) übertragen wird,
**daß** während des Anpassungsvorgangs die Amplitude oder die Impulsdauer des Ausgangssignals (s₇, g₁₀, g₁₁) des empfängerseitigen Dispersionsfilters (13, 32, 33) gemessen und die senderseitig verwendete Modulationscharakteristik oder das Gruppenlaufzeitverhalten des empfängerseitigen Dispersionsfilters (13, 32, 33) verändert wird, bis die Impulsdauer einen Minimalwert bzw. die Amplitude einen Maximalwert annimmt.

2. Verfahren nach Anspruch 1, **dadurch gekennzeichnet, daß** die Winkelmodulation und das weitere Modulationsverfahren mindestens annähernd orthogonale Modulationsarten sind.

3. Verfahren nach Anspruch 1 oder 2, **dadurch gekennzeichnet, daß** die Impulse entsprechend einer vorgegebenen Filtercharakteristik gefiltert werden, wobei die senderseitige Winkelmodulation und das empfängerseitige Gruppenlaufzeitverhalten des Dispersionsfilters (13; 32, 33) derart aufeinander abgestimmt sind, daß Signalanteile der winkelmodulierten Impulse (s₆) des Ausgangssignals (s₉, g₁₄) aufgrund der frequenzabhängig unterschiedlichen Signallaufzeit des Dispersionsfilters (13, 32, 33) an dessen Ausgang im wesentlichen koinzident und infolge der Überlagerung mit gegenüber dem Eingang erhöhter Amplitude erscheinen.

4. Verfahren nach einem der vorhergehenden Ansprüche, **dadurch gekennzeichnet, daß** das Eingangssignal (g₄) eine Trägerfrequenz aufweist, die im Sender (16 bis 26) jeweils impulsweise der Winkelmodulation unterworfen wird.

5. Verfahren nach Anspruch 4, **dadurch gekennzeichnet, daß** die Modulationscharakteristik der Winkelmodulation die zeitliche Änderung des Phasenwinkels jeweils während der Dauer eines Impulses bestimmt,
daß insbesondere die Amplitude der winkelmodulierten Impulse zur Aufprägung der im Eingangssignal (s₁) enthaltenen Nachricht in Abhängigkeit vom Eingangssignal (s₁) genutzt wird,
daß das Gruppenlaufzeitverhalten des Dispersionsf ilters (13) im Empfänger (11 bis 15) Frequenz-Zeit-Charakteristik der Sendeimpulse komplementär ist und
daß die Amplitude der von dem Dispersionsfilter (13) komprimierten Impulse zur Rückgewinnung der in dem Eingangssignal (s₁) enthaltenen Nachricht mittels eines Detektors (14, 15), insbesondere eines Amplitudendemodulators, ausgewertet wird.

6. Verfahren nach einem der vorhergehenden Ansprüche, **dadurch gekennzeichnet, daß** das weitere, die Nachricht aufprägende Modulationsverfahren insbesondere eine Pulspositionsmodulation (PPM), wahlweise auch eine Pulscodemodulation (PCM) oder eine differentielle Pulscodemodulation (DPCM) oder eine Pulsdeltamodulation (PDM) oder eine Modifikation eines oder mehrerer dieser Modulationsverfahren, ist.

7. Verfahren nach einem der Ansprüche 3 bis 6, **dadurch gekennzeichnet, daß** die im Sender winkelmodulierten Impulse im Empfänger (29 bis 37) einem Dispersionsfilterpaar (32, 33) zugeführt werden, wobei die Dispersionsfilter (32, 33) des Paares unterschiedliches Gruppenlaufzeitverhalten auf - weisen, das an die Modulationscharakteristik jeweils paarweise derart angepaßt ist, daß die Signalanteile der Impulse am Ausgang nur eines der Dispersionsfilter (32, 33) mit Amplitudenerhöhung erscheinen, während bei dem jeweils anderen Dispersionfilter (32, 33) eine gleichartige Amplitudenerhöhung nicht stattfindet, und daß die Amplituden am Ausgang der Dispersionsfilter (13; 32, 33) mittels eines Detektors (14, 15; 34, 35) vergleichend ausgewertet werden.

8. Verfahren nach Anspruch 7, **dadurch gekennzeichnet, daß** sich während der Pulsdauer der pulsmodulierten Signale der Winkel - die Frequenz oder die Phase - der Trägerfrequenz linear mit der Zeit von einer unteren Frequenz oder Phasenlage zu einer oberen Frequenz oder Phasenlage bzw. umgekehrt monoton ändert und daß das Dispersionsfilter im Empfänger ein komplementäres lineares Verhalten aufweist.

9. Verfahren nach einem der vorhergehenden Ansprüche, **dadurch gekennzeichnet, daß** die Modulationscharakteristik für die einzelnen Impulse einer Folge von Impulsen unterschiedlich gewählt ist derart, daß die Unterschiede einen Teil der Nachricht ausdrücken.

10. Verfahren nach einem der Ansprüche 7 bis 9 , **dadurch gekennzeichnet,**
**daß** der Signalfluß im Empfänger in zwei parallele Zweige mit jeweils zwei Dispersionsfiltern (39, 44, 40, 43) mit zueinander inversen Gruppenlaufzeitcharakteristiken aufgeteilt wird,
**daß** der Signalfluß in den beiden Zweigen jeweils während eines Impulses für einen vorgegebenen Zeitraum durchgeschaltet oder unterbrochen wird, wobei die Unterbrechung bzw. Durchschaltung synchron zum Übertragungstakt erfolgt und
**daß** die beiden Zweige ausgangsseitig durch einen Subtrahierer (45) zusammengeführt werden.

11. Sende- und Empfänger-Anordnung mit
einem Sender (2 bis 8, 16 bis 26) zur Aufnahme und Übertragung eines Eingangssignals (s₁, g₄), wobei der Sender (2 bis 8, 16 bis 26) zur Winkelmodulation des Eingangssignals (s₁, g₄) einen ersten Modulator (2 bis 6, 16 bis 24) aufweist sowie
einem Empfänger (11 bis 15, 29 bis 37), der zur Rückgewinnung des Eingangssignals (s₁, g₄) einen Demodulator (14, 15, 31 bis 37) aufweist, wobei
der erste Modulator (2 bis 6, 16 bis 24) winkelmodulierte Impulse entsprechend einer Modulationscharakteristik erzeugt, welche die zeitliche Änderung der Winkel oder Phasenlage jeweils während der Dauer eines Impulses bestimmt,wobei der erste Modulator (2 bis 6, 16 bis 24) zur Aufnahme des Eingangssignals (s₁, g₄) und zur Einstellung der Modulationscharakteristik in Abhängigkeit von dem Eingangssignal (s₁, g₄) einen Steuereingang aufweist und/oder
wobei der Sender (2 bis 8, 16 bis 26) zur zusätzlichen Modulation der winkelmodulierten Impulse in Abhängigkeit vom Eingangssignal (s₁, g₄) einen zweiten Modulator (4) aufweist, wobei
der Empfänger (11 bis 15, 29 bis 37) zur Filterung der senderseitig entsprechend der vorgegebenen Modulationscharakteristik winkelmodulierten Impulse mindestens ein Dispersionsfilter (13, 32, 33), insbesondere ein Oberflächenwellenfilter, mit einem vorgegebenen Gruppenlaufzeitverhalten aufweist, wobei
das Gruppenlaufzeitverhalten des Dispersionsfilters (13, 32, 33) zur Amplitudenerhöhung des Ausgangssignals (s₉, g₁₄) derart an die senderseitig verwendete Modulationscharakteristik angepaßt ist, daß die Signalanteile der entsprechend dieser Modulationscharakteristik winkelmodulierten Impulse aufgrund der frequenzabhängig unterschiedlichen Signallaufzeit durch das Dispersionsfilter (13, 32, 33) an dessen Ausgang zeitlich komprimiert und mit einer Amplitudenüberhöhung erscheinen.
**dadurch gekennzeichnet,**
**daß** der Empfänger (11 bis 15, 29 bis 37) ausgangsseitig ein Meßgerät aufweist zur Messung der Amplitude und/oder der Impulsdauer des Ausgangssignals (s₉, g₁₄) und
**daß** im Empfänger (11 bis 15, 29 bis 37) ein Stellglied vorgesehen ist zur Einstellung des Gruppenlaufzeitverhaltens des Dispersionsfilters (13, 32, 33), das, insbesondere über eine mit dem Meßgerät verbundene Steuereinheit, derart angesteuert wird, daß die Amplitude des Ausgangssignals einen Maximalwert bzw. die Impulsdauer des Ausgangssignals einen Minimalwert annimmt.

12. Anordnung nach Anspruch 11, **dadurch gekennzeichnet, daß** der erste Modulator (16 bis 24) winkelmodulierte Impulse erzeugt, wobei die Winkelmodulation in Abhängigkeit von dem am Steuereingang anliegenden Eingangssignal (g₄) entweder entsprechend einer vorgegebenen ersten Modulationscharakteristik oder entsprechend einer vorgegebenen zweiten Modulationscharakteristik erfolgt, daß der Empfänger (29 bis 37) zwei parallelgeschaltete Dispersionsfilter (32, 33) aufweist, wobei das unterschiedliche Gruppenlaufzeitverhalten der beiden Dispersionsfilter (32, 33) und die erste und zweite Modulationscharakteristik derart aneinander angepaßt sind, daß am Ausgang genau eines der beiden Dispersionsfilter (32, 33) die Signalanteile der winkelmodulierten Impulse zeitlich komprimiert und mit einer Amplitudenerhöhung erscheinen.

13. Anordnung nach Anspruch 11 oder 12 **dadurch gekennzeichnet,**
**daß** der senderseitige erste Modulator (16 bis 24) zur Erzeugung der entsprechend den beiden Modulationscharakteristiken winkelmodulierten Impulse jeweils ein Dispersionsfilter (22, 23) aufweist,
**daß** die in dem ersten Modulator (16 bis 24) angeordneten Dispersionsfilter (22, 23) eingangsseitig über ein steuerbares Schaltelement (21) mit einer Signalquelle (16 bis 20) verbunden sind, welche ein Hochfrequenzsignal (g₃) mit einer im wesentlichen si-förmigen Hüllkurve erzeugt,
**daß** das Schaltelement (21) zur Ansteuerung durch das Eingangssignal (g₄) mit dem Steuereingang des Modulators (16 bis 24) verbunden ist.

14. Anordnung nach Anspruch 11 oder 12, **dadurch gekennzeichnet,**
**daß** der erste Modulator (2 bis 6) winkelmodulierte Impulse erzeugt, wobei die Winkelmodulation unabhängig vom Eingangssignal (s₁) entsprechend einer vorgegebenen Modulationscharakteristik erfolgt, welche die zeitliche Änderung der Frequenz jeweils während der Dauer eines Impulses bestimmt,
**daß** der senderseitige zweite Modulator (4) zur Aufprägung der in dem Eingangssignal (s₁) enthaltenen Nachricht ein Amplitudenmodulator (4) ist, welcher die Amplitude der winkelmodulierten Impulse in Abhängigkeit von dem Eingangssignal (s₁) vorgibt,
**daß** der Empfänger (11 bis 15) zur Filterung der senderseitig entsprechend der vorgegebenen Modulationscharakteristik winkelmodulierten Impulse genau ein Dispersionsfilter (13) mit einem vorgegebenen Gruppenlaufzeitverhalten aufweist, welches derart an die senderseitig verwendete Modulationscharakteristik angepaßt ist, daß die Signalanteile jedes winkelmodulierten Impulses am Ausgang des Dispersionsfilters (13) zeitlich komprimiert und mit einer Amplitudenerhöhung erscheinen, und
**daß** dem Dispersionsfilter (13) zur Rückgewinnung der in dem Eingangssignal (s₁) enthaltenen Nachricht ein Detektor (14, 15) nachgeschaltet ist.

15. Anordnung nach einem der Ansprüche 11 bis 14 **dadurch gekennzeichnet, daß** Sender (2 bis 8, 16 bis 26) und Empfänger (11 bis 15, 29 bis 37) zur Ermöglichung eines wechselweisen Sende- und Empfangsbetriebs jeweils korrespondierende, im wesentlichen baugleiche Baugruppen zur Modulation bzw. Demodulation aufweisen, die jeweils mindestens ein Dispersionsfilter (6, 13, 22, 23, 32, 33) enthalten.

16. , Anordnung nach einem der Ansprüche 11 bis 15, **dadurch gekennzeichnet, daß** der Empfänger eine Rauschunterdrückungsschaltung (38, 47) aufweist, die im wesentlichen aus zwei parallel geschalteten Zweigen besteht, die ausgangsseitig mit den Eingängen eines Subtrahierers (45, 54) verbunden sind und in denen jeweils zwei Dispersionsfilter (39, 44, 40, 43, 48, 52, 49, 53) mit zueinander inversen Gruppenlaufzeitcharakteristiken in Reihe geschaltet sind, wobei in jedem der beiden Zweige zwischen den beiden Dispersionsfiltern (39, 44, 40, 43, 48, 52, 49, 53) zur Steuerung des Signalflusses ein Steuerelement (41, 42, 50, 51) angeordnet ist, das zur Synchronisation der Signalflußsteuerung mit dem Übertragungstakt mit einer Synchronisierungsschaltung (46, 55 bis 57) verbunden ist.

17. Anordnung nach Anspruch 16, **dadurch gekennzeichnet, daß** das Steuerelement ein Multiplizierer (50, 51) ist, der eingangsseitig mit dem vorgeschalteten Dispersionsfiltern (48, 49) und zur zeitgesteuerten Unterbrechung oder Freischaltung des Signalflusses mit der Synchronisierungsschaltung (55 bis 57) verbunden ist.

## Claims

1. Method for wireless transmission of a message, in particular for mobile communication, in which an input signal (s₁, g₄) in a transmitter (2 to 8; 16 to 26) is subjected to modulation and passes via a transmission channel to a receiver (11 to 15; 29 to 57), wherein in the transmitter angle-modulated pulses carrying the message and having a frequency spectrum are generated so as to be compressible in time in the receiver by means of a filter (13, 32, 33) with frequency-dependent differential delay time, also called the group delay time, in such a way that pulses with a shorter duration and higher amplitude than the pulses emitted are produced, and at least a part of the message in the transmitter is impressed on the pulses by means of a further modulation which is independent of angle modulation and/or used to control a parameter of angle modulation which can be detected in the receiver,
**characterised**
**in that** for matching of transmitter (2 to 8, 16 to 26) and receiver (11 to 15, 29 to 37) during a matching operation for balancing a preset digital reference signal is transmitted as the input signal (s₁, g₄),
**in that** during the matching operation the amplitude or the pulse duration of the output signal (s₇, g₁₀, g₁₁) of the dispersion filter (13, 32, 33) on the receiver side is measured and the modulation characteristic used on the transmitter side or the group delay time behaviour of the dispersion filter (13, 32, 33) on the receiver side is varied until the pulse duration assumes a minimum value or the amplitude assumes a maximum value.

2. Method according to claim 1, **characterised in that** the angle modulation and the further modulation process are at least approximately orthogonal types of modulation.

3. Method according to claim 1 or 2, **characterised in that** the pulses are filtered according to a preset filter characteristic, wherein the angle modulation on the transmitter side and the group delay time behaviour of the dispersion filter (13; 32, 33) on the receiver side are coordinated with each other in such a way that signal fractions of the angle-modulated pulses (s₆) of the output signal (s₉, g₁₄) appear substantially coincident due to the signal delay time of the dispersion filter (13, 32, 33) varying as a function of frequency at its output, and appear to have a higher amplitude than the input due to superposition.

4. Method according to any of the preceding claims, **characterised in that** the input signal (g₄) has a carrier frequency which in the transmitter (16 to 26) is respectively subjected to angle modulation in pulses.

5. Method according to claim 4, **characterised**
**in that** the modulation characteristic of angle modulation determines the variation in time of the phase angle respectively for the duration of a pulse,
**in that** in particular the amplitude of the angle-modulated pulses is used to impress the message contained in the input signal (s₁) as a function of the input signal (s₁),
**in that** the group delay time behaviour of the dispersion filter (13) in the receiver (11 to 15) is complementary to the frequency-time characteristic of the transmitted pulses and
**in that** the amplitude of the pulses compressed by the dispersion filter (13) is evaluated by means of a detector (14, 15), in particular an amplitude modulator, for retrieval of the message contained in the input signal (s₁).

6. Method according to any of the preceding claims, **characterised in that** the further modulation process which impresses the message is in particular pulse position modulation (PPM), optionally also pulse code modulation (PCM) or differential pulse code modulation (DPCM) or pulse delta modulation (PDM) or a modification of one or more of these modulation processes.

7. Method according to any of claims 3 to 6, **characterised in that** the pulses in the receiver (29 to 37) which were angle-modulated in the transmitter are delivered to a pair of dispersion filters (32, 33), wherein the dispersion filters (32, 33) of the pair have different group delay time behaviour which is matched to the modulation characteristic respectively in pairs in such a way that the signal fractions of the pulses at the output of only one of the dispersion filters (32, 33) appear with an increase of amplitude, while in the other dispersion filter (32, 33) an identical increase of amplitude does not take place, and **in that** the amplitudes at the output of the dispersion filters (13; 32, 33) are evaluated comparatively by means of a detector (14, 15; 34, 35).

8. Method according to claim 7, **characterised in that** for the pulse duration of the pulse-modulated signals the angle -the frequency or the phase - of the carrier frequency steadily varies linearly in time from a lower frequency or phase position to an upper frequency or phase position or vice versa and **in that** the dispersion filter in the receiver has a complementary linear behaviour.

9. Method according to any of the preceding claims, **characterised in that** the modulation characteristic for the individual pulses of a sequence of pulses is selected differently in such a way that the differences express a part of the message.

10. Method according to any of claims 7 to 9, **characterised in that** the signal flow in the receiver is divided into two parallel branches each with two dispersion filters (39, 44, 40, 43) with group delay time characteristics inverse to each other,
**in that** the signal flow in the two branches is switched through or interrupted in each case during one pulse for a preset period of time, wherein interruption or switching through takes place synchronously with the transmission cycle and
**in that** the two branches are combined on the output side by a subtractor (45).

11. Transmitter and receiver,assembly with
a transmitter (2 to 8, 16 to 26) for picking up and transmitting an input signal (s₁, g₄), wherein the transmitter (2 to 8, 16 to 26) has a first modulator (2 to 6, 16 to 24) for angle modulation of the input signal (s₁, g₄), and
a receiver (11 to 15, 29 to 37) which has a demodulator (14, 15, 31 to 37) for retrieval of the input signal (s₁, g₄), wherein
the first modulator (2 to 6, 16 to 24) generates angle-modulated pulses according to a modulation characteristic which determines the variation in time of the angles or phase position respectively for the duration of a pulse, wherein the first modulator (2 to 6, 16 to 24) has a control input for picking up the input signal (s₁, g₄) and for adjusting the modulation characteristic as a function of the input signal (s₁, g₄) and/or
wherein the transmitter (2 to 8, 16 to 26) has a second modulator (4) for additional modulation of the angle-modulated pulses as a function of the input signal (s₁, g₄), wherein
the receiver (11 to 15, 29 to 37) has at least one dispersion filter (13, 32, 33), in particular a surface acoustic wave filter, with a preset group delay time behaviour, for filtering the pulses which were angle-modulated on the transmitter side according to the preset modulation characteristic, wherein
the group delay time behaviour of the dispersion filter (13, 32, 33) is matched to the modulation characteristic used on the transmitter side, to increase the amplitude of the output signal (s₉, g₁₄), in such a way that the signal fractions of the pulses angle-modulated according to this modulation characteristic appear compressed in time and with an increase in amplitude due to the signal delay time through the dispersion filter (13, 32, 33) varying as a function of frequency at its output,
**characterised**
**in that** the receiver (11 to 15, 29 to 37) comprises a measuring device on the output side for measuring the amplitude and/or the pulse duration of the output signal (s₉, g₁₄) and
**in that** in the receiver (11 to 15, 29 to 37) is provided a final control element for adjusting the group delay time behaviour of the dispersion filter (13, 32, 33), which is controlled in particular via a control unit connected to the measuring device in such a way that the amplitude of the output signal assumes a maximum value or the pulse duration of the output signal assumes a minimum value.

12. Assembly according to claim 11, **characterised**
**in that** the first modulator (16 to 24) generates angle-modulated pulses, wherein angle modulation is effected as a function of the input signal (g₄) occurring at the control input either according to a preset first modulation characteristic or according to a preset second modulation characteristic,
**in that** the receiver (29 to 37) comprises two parallel-connected dispersion filters (32, 33), wherein the different group delay time behaviour of the two dispersion filters (32, 33) and the first and second modulation' characteristics are matched to each other in such a way that at the output of precisely one of the two dispersion filters (32, 33) the signal fractions of the angle-modulated pulses appear compressed in time and with an increase of amplitude.

13. Assembly according to claim 11 or 12, **characterised**
**in that** the first modulator (16 to 24) on the transmitter side for generating the pulses angle-modulated according to the two modulation characteristics has in each case a dispersion filter (22, 23),
**in that** the dispersion filters (22, 23) arranged in the first modulator (16 to 24) are connected on the input side via a controllable switching element (21) to a signal source (16 to 20) which generates a high-frequency signal (g₃) with a substantially si-shaped envelope curve,
**in that** the switching element (21) for control by the input signal (g₄) is connected to the control input of the modulator (16 to 24).

14. Assembly according to claim 11 or 12, **characterised**
**in that** the first modulator (2 to 6) generates angle-modulated pulses, wherein angle modulation is effected independently of the input signal (s₁) according to a preset modulation characteristic which determines the variation in time of the frequency respectively for the duration of a pulse,
**in that** the second modulator (4) on the transmitter side for impressing the message contained in the input signal (s₁) is an amplitude modulator (4) which presets the amplitude of the angle-modulated pulses as a function of the input signal (s₁),
**in that** the receiver (11 to 15) for filtering the pulses angle-modulated on the transmitter side according to the preset modulation characteristic comprises precisely one dispersion filter (13) with a preset group delay time behaviour which is matched to the modulation characteristic used on the transmitter side in such a way that the signal fractions of each angle-modulated pulse at the output of the dispersion filter (13) appear compressed in time and with an increase of amplitude, and
**in that** a detector (14, 15) is connected to the output of the dispersion filter (13) for retrieval of the message, contained in the input signal (s₁).

15. Assembly according to any of claims 11 to 14, **characterised in that** transmitter (2 to 8, 16 to 26) and receiver (11 to 15, 29 to 37) have units of substantially the same construction for modulation or demodulation, which in each case correspond to allow alternate transmission and reception and which each contain at least one dispersion filter (6, 13, 22, 23, 32, 33).

16. Assembly according to any of claims 11 to 15, **characterised in that** the receiver has a noise suppression circuit (38, 47) which essentially consists of two parallel-connected branches which are connected on the output side to the inputs of a subtractor (45, 54) and in which respectively two dispersion filters (39, 44, 40, 43, 48, 52, 49, 53) with group delay time characteristics inverse to each other are connected in series, wherein in each of the two branches between the two dispersion filters (39, 44, 40, 43, 48, 52, 49, 53) for control of the signal flow is arranged a control element (41, 42, 50, 51) which for synchronisation of signal flow control with the transmission cycle is connected to a synchronising circuit (46, 55 to 57).

17. Assembly according to claim 16, **characterised in that** the control element is a multiplier (50, 51) which on the input side is connected to the dispersion filters (48, 49) in front and for time-controlled interruption or clearance of signal flow is connected to the synchronising circuit (55 to 57).

## Revendications

1. Procédé pour la transmission sans fil d'une information, en particulier pour la communication mobile, dans lequel un signal d'entrée (s₁, g₄) est soumis à une modulation dans un émetteur (2 à 8 ; 16 à 26) et parvient à travers un canal de transmission à un récepteur (11 à 15 ; 29 à 57),
moyennant quoi des impulsions portant l'information, présentant un spectre de fréquences et modulées angulairement sont générées dans l'émetteur de telle sorte qu'elles peuvent être comprimées en temps dans le récepteur au moyen d'un filtre (13, 32, 33) avec un temps de propagation différentiel dépendant de la fréquence, appelé également temps de propagation de groupe, de telle sorte qu'il se forme des impulsions avec une durée raccourcie par rapport aux impulsions envoyées et une amplitude augmentée, et
au moins une partie de l'information étant attribuée aux impulsions dans l'émetteur au moyen d'une autre modulation indépendante de la modulation angulaire et/ou étant utilisée pour la commande d'un paramètre de la modulation angulaire, pouvant être enregistré dans le récepteur,
**caractérisé en ce que**
un signal de référence numérique prédéfini est transmis comme signal d'entrée (s₁, g₄) pour l'ajustement de l'émetteur (2 à 8, 16 à 26) et du récepteur (11 à 15, 29 à 37) pendant une opération d'ajustement pour l'équilibrage,
**en ce que**, pendant l'opération d'ajustement, l'amplitude ou la durée d'impulsion du signal de sortie (s₇, g₁₀, g₁₁) du filtre de dispersion (13, 32, 33) côté récepteur est mesurée et la caractéristique de modulation utilisée côté émetteur ou la caractéristique de temps de propagation de groupe du filtre de dispersion côté récepteur (13, 32, 33) est modifiée jusqu'à ce que la durée d'impulsion prenne une valeur minimale ou que l'amplitude prenne une valeur maximale.

2. Procédé selon la revendication 1, **caractérisé en ce que** la modulation angulaire et l'autre procédé de modulation sont des types de modulation au moins approximativement orthogonaux.

3. Procédé selon la revendication 1 ou 2, **caractérisé en ce que** les impulsions sont filtrées en fonction d'une caractéristique de filtre prédéfinie, la modulation angulaire côté émetteur et la caractéristique de temps de propagation de groupe côté récepteur du filtre de dispersion (13 ; 32, 33) sont réciproquement adaptées de telle sorte que des parties de signal des impulsions (s₆) modulées angulairement du signal de sortie (s₉, g₁₄) apparaissent en coïncidant sensiblement en raison du temps de propagation de signal, dépendant de la fréquence, du filtre de dispersion (13, 32, 33) à la sortie de ce filtre et avec une amplitude augmentée par rapport à l'entrée en raison de la superposition.

4. Procédé selon l'une quelconque des revendications précédentes, **caractérisé en ce que** le signal d'entrée (g₄) présente une fréquence porteuse qui est soumise à la modulation angulaire dans l'émetteur (16 à 26) à chaque fois par impulsions.

5. Procédé selon la revendication 4, **caractérisé en ce que** la caractéristique de modulation de la modulation angulaire détermine la variation dans le temps de l'angle de phase respectivement pendant la durée d'une impulsion,
**en ce qu'**en particulier l'amplitude des impulsions modulées angulairement est utilisée pour la caractérisation de l'information contenue dans le signal d'entrée (s₁) en fonction du signal d'entrée (s₁),
**en ce que** la caractéristique de temps de propagation de groupe du filtre de dispersion (13) dans le récepteur (11 à 15) est complémentaire de la caractéristique fréquence-temps des impulsions d'émission et
**en ce que** l'amplitude des impulsions comprimées par le filtre de dispersion (13) est analysée pour récupérer l'information contenue dans le signal d'entrée (s₁) au moyen d'un détecteur (14, 15), en particulier d'un modulateur d'amplitude.

6. Procédé selon l'une quelconque des revendications précédentes, **caractérisé en ce que** l'autre procédé de modulation caractérisant l'information est en particulier une modulation d'impulsions en position (PIM), éventuellement également une modulation par impulsions et codage (MIC) ou une modulation par impulsions et codage différentiel (MICD) ou une modulation d'impulsions en durée (MID) ou une modification de l'un ou de plusieurs de ces procédés de modulation.

7. Procédé selon l'une quelconque des revendications 3 à 6, **caractérisé en ce que** les impulsions modulées en angle dans l'émetteur sont amenées à une paire de filtres de dispersion (32, 33) dans le récepteur (29 à 37), les filtres de dispersion (32, 33) de la paire présentant une caractéristique de temps de propagation de groupe différente, qui est adaptée à la caractéristique de modulation respectivement par paires de telle sorte que les parties de signal des impulsions apparaissent à la sortie de seulement l'un des filtres de dispersion (32, 33) avec une augmentation d'amplitude, alors qu'on n'a pas une augmentation d'amplitude du même type sur l'autre filtre de dispersion (32, 33) concerné, et **en ce que** les amplitudes à la sortie des filtres de dispersion (13 ; 32, 33) sont analysées à titre comparatif au moyen d'un détecteur (14, 15 ; 34, 35).

8. Procédé selon la revendication 7, **caractérisé en ce que**, pendant la durée d'impulsion des signaux modulés par impulsions, l'angle - la fréquence ou la phase - de la fréquence porteuse varie de façon linéaire ou inversement monotone avec le temps d'une fréquence ou position de phase inférieure vers une fréquence ou position de phase supérieure et **en ce que** le filtre de dispersion présente dans le récepteur un comportement linéaire complémentaire.

9. Procédé selon l'une quelconque des revendications précédentes, **caractérisé en ce que** la caractéristique de modulation pour les différentes impulsions d'une succession d'impulsions est choisie différente de telle sorte que les différences expriment une partie de l'information.

10. Procédé selon l'une quelconque des revendications 7 à 9, **caractérisé en ce que**
le flux de signal est divisé dans le récepteur en deux branches parallèles avec respectivement deux filtres de dispersion (39 ; 44, 40, 43) avec des caractéristiques de temps de propagation de groupe qui sont inversées les unes par rapport aux autres,
**en ce que** le flux de signal dans les deux branches est connecté ou interrompu respectivement pendant une impulsion pour une période prédéfinie, l'interruption ou la connexion s'effectuant de façon synchrone avec le cycle de transmission et
**en ce que** les deux branches sont regroupées côté sortie par un soustracteur (45).

11. Dispositif d'émission et de réception, avec un émetteur (2 à 8, 16 à 26) pour la réception et la transmission d'un signal d'entrée (s₁, g₄), l'émetteur (2 à 8, 16 à 26) présentant un premier modulateur (2 à 6, 16 à 24) pour la modulation angulaire du signal d'entrée (s₁, g₄) et un récepteur (11 à 15, 29 à 37), qui présente un démodulateur (14, 15, 31 à 37) pour la récupération du signal d'entrée (s₁, g₄),
le premier modulateur (2 à 6, 16 à 24) générant des impulsions modulées angulairement en fonction d'une caractéristique de modulation, qui détermine la variation dans le temps des angles ou de la position de phase respectivement pendant la durée d'une impulsion, le premier modulateur (2 à 6, 16 à 24) présentant une entrée de commande pour la réception du signal d'entrée (s₁, g₄) et pour le réglage de la caractéristique de modulation en fonction du signal d'entrée (S₁, G₄) et/ou
l'émetteur (2 à 8, 16 à 26) présentant un second modulateur (4) pour la modulation supplémentaire des impulsions modulées angulairement en fonction du signal d'entrée (s₁, g₄)
le récepteur (11 à 15, 29 à 37) présentant au moins un filtre de dispersion (13, 32, 33), en particulier un filtre à ondes acoustiques de surface, avec une caractéristique prédéfinie de temps de propagation de groupe pour le filtrage des impulsions modulées angulairement en fonction de la caractéristique prédéfinie de modulation,
la caractéristique de temps de propagation de groupe du filtre de dispersion (13, 32, 33) étant adaptée pour l'augmentation en amplitude du signal de sortie (s₉, g₁₄) à la caractéristique de modulation utilisée côté émetteur de telle sorte que les parts de signal des impulsions modulées angulairement en fonction de cette caractéristique de modulation sont comprimées dans le temps par le filtre de dispersion (13, 32, 33) à sa sortie en raison du temps de propagation du signal différent en fonction de la fréquence et apparaissent avec une augmentation en amplitude,
**caractérisé en ce que**,
le récepteur (11 à 15, 29 à 37) présente côté sortie un appareil de mesure pour la mesure de l'amplitude et/ou de la durée d'impulsion du signal de sortie (s₉, g₁₄) et **en ce qu'**un actionneur est prévu dans le récepteur (11 à 15, 29 à 37) pour le réglage de la caractéristique de temps de propagation de groupe du filtre de dispersion (13, 32, 33), qui est amorcé, en particulier au moyen d'une unité de commande reliée à l'appareil de mesure, de telle sorte que l'amplitude du signal de sortie prend une valeur maximale, respectivement la durée d'impulsion du signal de sortie prend une valeur minimale.

12. Dispositif selon la revendication 11, **caractérisé en ce que** le premier modulateur (16 à 24) génère des impulsions modulées angulairement, la modulation angulaire s'effectuant en fonction du signal d'entrée (g₄) s'appliquant à l'entrée de commande soit en fonction d'une première caractéristique de modulation prédéfinie soit en fonction d'une seconde caractéristique de modulation prédéfinie,
**en ce que** le récepteur (29 à 37) présente deux filtres de dispersion (32, 33) montés en parallèle, la caractéristique de temps de propagation de groupe différente des deux filtres de dispersion (32, 33) et les première et seconde caractéristiques de modulation étant adaptées entre elles de telle sorte que, à la sortie de précisément l'un des deux filtres de dispersion (32, 33), les parties de signal des impulsions modulées angulairement apparaissent comprimées dans le temps et avec une augmentation d'amplitude.

13. Dispositif selon la revendication 11 ou 12,
**caractérisé en ce que**
le premier modulateur (16 à 24) côté émetteur présente respectivement un filtre de dispersion (22, 23) pour la génération des impulsions modulées angulairement en fonction des deux caractéristiques de modulation,
**en ce que** les filtres de dispersion (22, 23) disposés dans le premier modulateur (16 à 24) sont reliés à une source de signal (16 à 20) côté entrée au moyen d'un élément de commutation (21) contrôlable, laquelle source génère un signal de haute fréquence (g₃) avec une courbe enveloppante sensiblement sinusoïdale,
**en ce que** l'élément de commutation (21) est relié à l'entrée de commande du modulateur (16 à 24) pour l'amorçage par le signal d'entrée (g₄).

14. Dispositif selon la revendication 11 ou 12,
**caractérisé en ce que**
le premier modulateur (2 à 6) génère des impulsions modulées en angle, la modulation angulaire s'effectuant indépendamment du signal d'entrée (s₁) en fonction d'une caractéristique de modulation prédéfinie, qui détermine la variation dans le temps de la fréquence respectivement pendant la durée d'une impulsion,
**en ce que** le second modulateur (4) côté émetteur pour la caractérisation de l'information contenue dans le signal d'entrée (s₁) est un modulateur d'amplitude (4), qui prédéfinit l'amplitude des impulsions modulées angulairement en fonction du signal d'entrée (si),
**en ce que** le récepteur (11 à 15) présente pour le filtrage des impulsions modulées angulairement côté émetteur en fonction de la caractéristique de modulation prédéfinie précisément un filtre de dispersion (13) avec une caractéristique de temps de propagation de groupe prédéfinie qui est adaptée à la caractéristique de modulation utilisée côté émetteur de telle sorte que les parties de signal de chaque impulsion modulée angulairement apparaissent à la sortie du filtre de dispersion (13) comprimées dans le temps et avec une augmentation d'amplitude, et
**en ce qu'**un détecteur (14, 15) est monté en aval du filtre de dispersion (13) pour la récupération de l'information contenue dans le signal d'entrée (s₁).

15. Dispositif selon l'une quelconque des revendications 11 à 14, **caractérisé en ce que**
l'émetteur (2 à 8, 16 à 26) et le récepteur (11 à 25, 29 à 37) présentent des ensembles pour la modulation et la démodulation qui se correspondent à chaque fois et sont sensiblement identiques afin de permettre un mode d'émission et de réception en. alternance, et qui contiennent à chaque fois au moins un filtre de dispersion (6, 13, 22, 23, 32, 33).

16. Dispositif selon l'une quelconque des revendications 11 à 15, **caractérisé en ce que** le récepteur présente un circuit de suppression de bruit (38, 47) comprenant essentiellement deux branches montées en parallèle qui sont reliées côté sortie aux entrées d'un soustracteur (45, 54) et dans lesquelles respectivement deux filtres de dispersion (39, 44, 40, 43, 48, 52, 49, 53) avec des caractéristiques de temps de propagation de groupe inversées les unes par rapport aux autres sont montés en série, un élément de commande (41, 42, 50, 51) étant disposé dans chacune des deux branches entre les deux filtres de dispersion (39, 44, 40, 43, 48, 52, 49, 53) pour la commande du flux de signal, lequel élément de commande est relié à un circuit de synchronisation (46, 55 à 57) pour la synchronisation de la commande du flux de signal avec le cycle de transmission.

17. Dispositif selon la revendication 16, **caractérisé en ce que** l'élément de commande est un multiplicateur (50, 51) qui est relié côté entrée aux filtres de dispersion (48, 49) montés en amont et.au circuit de synchronisation (55 à 57) pour l'interruption ou la libération commandée dans le temps du flux de signal.
